# EUROPÄISCHE PATENTSCHRIFT

(11) **EP 2 914 967 B1**
(45) Veröffentlichungstag und Bekanntmachung des Hinweises auf die Patenterteilung: **26.05.2021**
(21) Anmeldenummer: 13788888.9
(22) Anmeldetag: 31.10.2013
(51) Int. Cl.: G01R 15/08, G01R 15/18, G01R 19/20

(54) **GERÄT ZUR ISOLIERTEN MESSUNG VON STROM UND VERFAHREN ZUR ISOLIERTEN ERMITTLUNG VON STROM**
DEVICE FOR THE INSULATED MEASUREMENT OF CURRENT AND A METHOD FOR THE INSULATED DETERMINATION OF CURRENT
APPAREIL POUR LA MESURE ISOLÉE D'UN COURANT ET PROCÉDÉ POUR LA DÉTERMINATION ISOLÉE D'UN COURANT

(30) Priorität: 02.11.2012 DE 102012021364
(43) Veröffentlichungstag der Anmeldung: 09.09.2015
(73) Patentinhaber: Sieva D.O.O. - Poslovna Enota Idrija, 5280 Idrija (SI)
(72) Erfinder: PLATISE, Uros, 400 Kranj (SI)
(74) Vertreter: Grättinger Möhring von Poschinger Patentanwälte Partnerschaft mbB
(86) Internationale Anmeldenummer: PCT/EP2013/003278
(87) Internationale Veröffentlichungsnummer: WO 2014/067660

(56) Entgegenhaltungen:
- EP-A1- 1 542 025
- EP-A2- 0 132 745
- DE-A1- 10 110 475
- GB-A- 1 481 263

## Beschreibung

Die Erfindung betrifft ein Gerät zur isolierten Messung von Strom, welches einen magnetischen Kern mit wenigstens einem Messbereich und einem Durchbruch, durch welchen ein Primärleiter verläuft, eine Kompensationswicklung, welche um Teile des Kerns außerhalb des Messbereichs gewickelt ist, wenigstens eine Erregerwicklung und wenigstens eine Messwicklung umfasst. Außerdem betrifft die Erfindung ein Verfahren zur isolierten Ermittlung von Strom unter Verwendung eines vorgenannten Geräts zur isolierten Messung von Strom.

Genannte Geräte werden üblicherweise für die isolierte Messung sehr hoher Gleichströme aber auch Wechselströme eingesetzt, wobei ein stromführender Primärleiter, dessen Strom zu messen ist, in einem magnetischen Kern einen magnetischen Fluss hervorruft, welcher proportional zu dem zu messenden Strom ist. Der magnetische Kern weist Hilfsmittel auf, mit denen sein Magnetfeld beeinflusst bzw. erfasst werden kann, wodurch eine indirekte Messung des Stromes ermöglicht wird. Dieses Prinzip bietet den Vorteil, dass der stromführende Primärleiter keine galvanische Verbindung mit dem magnetischen Kern bzw. dessen Hilfsmitteln eingehen muss. Derartige Vorrichtungen und Verfahren der isolierten Strommessung, sind in unterschiedlichster Weise durch den Stand der Technik offenbart.

Sehr geläufig ist der Einsatz von Hallsonden zur Erfassung von Magnetfeldern magnetischer Kerne. Bei diesem Prinzip ist ein stromführender Primärleiter durch einen von einer Kompensationsspule umwickelten magnetischen Kern geführt, welcher einen Spalt aufweist in dem eine Hallsonde angeordnet ist. Der stromführende Primärleiter ruft in dem magnetischen Kern einen magnetischen Primärfluss, die Kompensationswicklung einen von einem durch die Hallsonde gemessenen magnetischen Fluss abhängigen, dem Primärfluss entgegenwirkenden Kompensationsfluss hervor. Der dieser Messanordnung immanente Luftspalt erschwert eine störflussfreie Führung von magnetischem Fluss, begrenzt die Messgenauigkeit und ist abhängig von der Größe der in dem Luftspalt angeordneten Hallsonde. Einschlägigen Stand der Technik bilden insoweit beispielsweise die DE-10011047-A1, US-4639665-A oder die GB-2237114-A.

Aus der GB-1488262-A sind eine Vorrichtung und ein Verfahren zur berührungslosen Messung von Gleichstrom in einem stromführenden Primärleiter bekannt. Die Vorrichtung umfasst einen geschlossenen magnetischen Kern mit einer Erregerwicklung, einer Messwicklung, einer Kompensationswicklung und einem stromführenden Primärleiter. Die Erregerwicklung ist an eine Signalquelle zur Erzeugung eines alternierenden Signals, die Messwicklung an den Eingang und die Kompensationswicklung an den Ausgang eines Schaltkreises angeschlossen. Der stromführende Primärleiter induziert einen magnetischen Fluss in den magnetischen Kern, die Erregerwicklung sättigt den magnetischen Kern durch den Wechselstrom in jedem halben Zyklus und produziert dadurch ein pulsierendes Signal in der Messwicklung. Der Schaltkreis steuert mittels des Pulsweitenverhältnisses des pulsierenden Signals der Erregerspannung einen in die Kompensationswicklung einleitbaren und messbaren Kompensationsstrom, welcher einen magnetischen Fluss in den magnetischen Kern induziert und den durch den stromführenden Primärleiter erzeugten magnetischen Fluss ausgleicht. In der durch GB-1488262-A offenbarten Vorrichtung wird ein relativ großer Abschnitt des magnetischen Kerns durch die Erregerwicklung gesättigt, was den magnetischen Kern anfällig für Remanenz macht und relativ viel Energie verbraucht. Des Weiteren reagiert die Vorrichtung mit 0,02 s relativ langsam auf Stromänderungen des stromführenden Primärleiters und ist nicht dazu eingerichtet, sowohl hohe Gleichströme als auch Wechselströme in einer großen Bandweite zu messen.

GB-1481263-A zeigt ein Messgerät zur isolierten Strommessung eines stromführenden Primärleiters, welcher einen magnetischen Fluss in einen magnetischen Kern induziert. Das Messgerät umfasst einen offenen magnetischen Kern mit einer Mehrzahl an Pfaden unterschiedlicher Breite zur Bereitstellung mehrerer Wege für den durch den stromführenden Primärleiter induzierten magnetischen Fluss. Einer dieser Pfade weist zur Vermeidung magnetischer Sättigung des magnetischen Kerns einen Spalt auf, welcher zeitweise vergrößert werden kann, um den stromführenden Primärleiter in den magnetischen Kern einzuführen. Ein Paar von Erregerwicklungen ist um einen schmalen Pfad des magnetischen Kerns gewickelt und dazu eingerichtet, abwechselnd magnetischen Fluss in entgegengesetzten Richtungen in den Pfad zu induzieren und diesen magnetisch zu sättigen. Das Messgerät weist ferner Mittel zum Vergleich der positiven und negativen Induktionsspitzen auf, woraus die Stärke des Stromes ermittelt wird, welcher durch den stromführenden Primärleiter fließt. Für die Strommessung mit dem Messgerät gemäß GB-1481263-A sind stets zwei Erregerwicklungen mit entsprechenden Schaltungselementen notwendig. Nachteilig ist, dass ein relativ großer Bereich des magnetischen Kerns durch die Erregerwicklungen gesättigt wird, wodurch das Messgerät relativ viel Energie verbraucht. Des Weiteren ist keine Kompensationswicklung vorgesehen, wodurch die Messung sehr hoher Ströme nicht oder nur mit entsprechend großer Dimensionierung des Messgeräts möglich ist. Des Weiteren macht die magnetische Sättigung des Kerns diesen durch die nicht vorhandene Kompensationswicklung anfällig für Remanenzeffekte, welchen durch den Luftspalt entgegnet werden soll. Der Luftspalt wirkt sich jedoch nachteilig auf die Messgenauigkeit und den erfassbaren Messbereich aus.

Durch EP-1542025-A1 werden mehrere Vorrichtungen und Verfahren zur indirekten Erfassung von Strom mit sogenannten magnetischen Brücken offenbart, welche einen magnetischen Kern in drei Pfade aufteilen. Die magnetischen Brücken sind dazu eingerichtet, ein magnetisches Feld eines stromführenden Primärleiters, dessen Strom gemessen werden soll, zu erkennen. Mittels einer optionalen Kompensationswicklung kann der magnetische Fluss des stromführenden Primärleiters ausgeglichen werden. Gezeigt werden Vorrichtungen mit magnetischen Brücken, bei denen zwei äußere Pfade von jeweils einer sinusförmig erregten Wicklung umwickelt sind. Die Erregung der Wicklungen kann hierbei gegensätzlich mit gleicher Amplitude erfolgen, wodurch beide Wicklungen einen sich aufhebenden magnetischen Fluss in dem zwischen ihnen angeordneten mittleren Pfad hervorrufen sollen. Diese sogenannte "magnetische Balance" wird zunächst gestört, sobald ein Strom durch den Primärleiter fließt und anschließend durch Anpassung der Erregung der Erregerwicklungen wieder hergestellt. Durch unterschiedliche Vorrichtungen und Verfahren wird diese Anpassung der Erregung genutzt, um den durch den stromführenden Primärleiter fließenden Strom indirekt zu ermitteln. Nachteilig an den durch EP-1542025-A1 gezeigten Vorrichtungen ist, dass der stromführende Primärleiter - sofern vorgesehen - durch den Messbereich geführt ist, wodurch unerwünschte Wechselwirkungen zwischen dem durch den stromführenden Primärleiter in der magnetischen Brücke hervorgerufenen magnetischen Fluss und dem der Erregerwicklungen entstehen können. Zudem ist die Widerherstellung der magnetischen Balance umständlich und aufwendig. Außerdem wird durch die Erregerwicklungen stets in einem sehr großen Bereich und in den meisten Fällen sogar in dem gesamten Bereich des magnetischen Kerns durch die Erregerwicklung ein magnetischer Wechselfluss hervorgerufen, wodurch das Auftreten unerwünschter Remanenzeffekte begünstigt und der Energieverbrauch erhöht wird.

EP 0 132 745 A2 zeigt eine nach dem Nullflussprinzip arbeitende Einrichtung zur Messung von Gleichströmen. Die Einrichtung umfasst einen magnetischen Kern mit Isthmus, einen Primärleiter, eine Kompensationswicklung, eine Indikatorwicklung und eine Vormagnetisierungswicklung, wobei der Isthmus eine verengte Strecke des Kerns darstellt, welche z.B. durch wenigstens eine Bohrung durch den Kernquerschnitt erzeugt wird. Die Indikatorwicklung liefert eine Eingangsgröße für einen Differenzverstärker und bewirkt zusammen mit Letzterem, dass in der Kompensationswicklung ein Strom fließt, welcher im Kern zu einem resultierenden Fluss nahe Null führt. Die Vormagnetisierungswicklung ist mit einem Wechselstrom beaufschlagt. Im Bereich des Isthmus besteht der Kern aus einer Parallelschaltung von wenigstens zwei magnetischen Leitern, wovon einer sowohl die Vormagnetisierungswicklung als auch die Indikatorwicklung trägt. Dadurch soll erreicht werden, dass lediglich ein kleines Volumen des Kerns, nämlich der die Vormagnetisierungswicklung und die Indikatorwicklung tragende Leiter, der Ummagnetisierung bedarf. Nachteilig ist jedoch insbesondere, dass die Vormagnetisierungswicklung in allen Leitern des Isthmus und in Teilen des Kerns magnetische Störflüsse und Rauschen hervorruft, was die Erzeugung des Nullfluss-Zustands in dem Kern behindert und sich nachteilig auf die Messgenauigkeit der Einrichtung auswirkt. In einem Ausführungsbeispiel umfasst der Kern zwei voneinander getrennte, aus jeweils einer Parallelschaltung von drei magnetischen Leitern bestehende Isthmen, wobei sowohl die Indikatorwicklung als auch die Vormagnetisierungswicklung jeweils ausschließlich auf dem mittleren Leiter der Isthmen aufgebracht sind. Hierdurch soll es möglich sein, den Einfluss von Fremdfeldern zu unterdrücken, wenn die Induktionswicklungen so geschaltet sind, dass sich der Einfluss von Fremdfeldern kompensiert. Das Vorsehen von zwei Isthmen ist jedoch insbesondere aufwendig in der Herstellung und sorgt für eine hohe Leistungsaufnahme.

Aufgabe der Erfindung ist es daher, ein einfaches, kompaktes und präzises Gerät mit geringer Leistungsaufnahme zur isolierten Messung von sehr hohen Gleichströmen und auch Wechselströmen in einer großen Bandweite der eingangs genannten Art mit erhöhter Störunterdrückung und wenig Remanenzeffekten sowie ein Verfahren zur isolierten Ermittlung von Strom unter Verwendung eines vorgenannten Geräts bereitzustellen.

Diese Aufgabe wird mit dem Gerät zur Messung von Strom nach Anspruch 1 und dem Verfahren zur Ermittlung von Strom nach Anspruch 13 gelöst.

Das erfindungsgemäße Gerät zur Messung von Strom zeichnet sich in funktioneller Kombination mit den eingangs erwähnten Merkmalen insbesondere dadurch aus, dass der magnetische Kern wenigstens einen Messbereich mit wenigstens zwei Durchbrüchen aufweist, welche den Messbereich in wenigstens drei benachbarte Flusspfade teilen, wenigstens zwei Flusspfade von wenigstens einer Erregerwicklung umwickelt sind und die Messwicklung um Teile des wenigstens einen Messbereichs gewickelt ist.

Mit dem Gerät ist es möglich, die Stromstärke des stromführenden Primärleiters zu ermitteln, wobei das Gerät dazu eingerichtet ist, die Stromstärke der Kompensationswicklung zu messen. Letztere Stromstärke ist in die Stromstärke des stromführenden Primärleiters umrechenbar. Der stromführende Primärleiter sollte, sofern er nicht - wie ebenfalls vorgesehen sein kann - mit einer oder mehreren Windungen um einen Schenkel des Kerns gewickelt ist, dabei einen nicht zu großen Abstand zu dem Gerät aufweisen, um störende Einflüsse von anderen magnetischen Fluss erzeugenden Elementen möglichst gering zu halten, und nicht durch die Durchbrüche des Messbereichs bzw. der Messbereiche geführt sein. Der stromführende Primärleiter sollte bevorzugt Gleichstrom führen, wobei das Gerät jedoch auch dazu eingerichtet ist, Wechselströme des stromführenden Primärleiters zu messen.

Der im Ganzen beispielsweise ringförmige oder quaderförmige Kern, z.B. aus einem ferromagnetischen Werkstoff, weist bevorzugt einen geschlossenen Querschnitt auf. Durch geschlossene Querschnitte können besonders hohe Permeabilitätswerte erreicht werden, was zu einer besonders hohen Sensitivität führt. Der in dem Kern erzeugte magnetische Fluss kann dadurch besonders gut geführt werden, was sich positiv auf die Messgenauigkeit auswirkt. Es gibt jedoch auch Anwendungsfälle, z.B. wenn das Gerät der Gefahr schwerer Schocks ausgesetzt ist, bei denen ein offener Querschnitt notwendigerweise - unter Inkaufnahme eines Verlusts an Messgenauigkeit - vorgesehen werden kann. Ein mit dem offenen Querschnitt einhergehender Luftspalt kann dann vorzugsweise außerhalb des Messbereichs vorgesehen sein. Durch einen solchen Luftspalt kann neben der vorgenannten Erhöhung der Widerstandsfähigkeit gegen Schockwirkungen auch entstehende Remanenz reduziert werden.

Der Kern weist in seinem wenigstens einen Messbereich wenigstens jeweils zwei Durchbrüche auf, welche bei ringförmigen oder quaderförmigen Kernen in besonders einfacher Weise deren Oberseiten miteinander verbinden können, wobei jedoch auch eine Verbindung der Seitenflächen möglich ist. Die Messbereiche sind in Relation zu der Gesamtgröße des Kerns vorzugsweise relativ klein, wodurch etwaige unerwünschte in dem Messbereich verursachte Störungen (wie beispielsweise Störflüsse) weniger Einfluss auf den Kern und das Gerät als Ganzes haben. Die Durchbrüche können unter anderem durch kreisrund gebohrte Löcher oder durch Öffnungen mit rechteckigem Querschnitt gebildet werden. Durch die wenigstens zwei Durchbrüche wird jeder Messbereich in wenigstens drei benachbarte Flusspfade geteilt. Ein Flusspfad bildet dabei einen Teil des Messbereichs bzw. des Kerns, in dem ein magnetischer Fluss vorhanden sein kann, wobei es möglich ist, den Kern in einem Messbereich bzw. in mehreren Messbereichen in drei benachbarte Flusspfade (bei Vorsehen von zwei Durchbrüchen), vier benachbarte Flusspfade (bei Vorsehen von drei Durchbrüchen) usw. zu teilen.

Eine Kompensationswicklung ist außerhalb des wenigstens einen Messbereichs angeordnet und um Teile des Kerns, beispielsweise einen Schenkel des Kerns, gewickelt. Durch die Kompensationswicklung kann ein Strom geleitet werden, welcher einen zu diesem proportionalen magnetischen Fluss in dem Kern hervorruft, welcher derart regelbar ist, dass der magnetische Fluss, welcher durch den stromführenden Primärleiter hervorgerufen wurde, idealer Weise vollständig und in der Praxis zumindest annähernd ausgeglichen werden kann. Unter dieser Voraussetzung ist der Strom in der Kompensationswicklung proportional zu dem Strom in dem Primärleiter. Durch eine entsprechende Wicklungszahl der Kompensationswicklung, welche in der Praxis typischerweise zwischen 500 und mehr als 2000 liegen kann, ist es möglich, den für diesen Ausgleich nötigen Strom auf einen Bruchteil des Stromes zu begrenzen, welcher durch den stromführenden Primärleiter fließt. Dieser mit "Null-Fluss" bezeichnete Zustand des Kerns bzw. Betriebsmodus des Geräts ermöglicht eine sehr genaue Messung.

Der Messbereich besteht aus wenigstens drei Flusspfaden, von denen wenigstens zwei Flusspfade von einer gemeinsamen oder zwei einzelnen Erregerwicklungen umwickelt sind. Die umwickelten Flusspfade können dabei entweder direkt benachbart oder aber durch wenigstens einen Flusspfad voneinander beabstandet sein. Mit steigender Gesamtanzahl von Durchbrüchen und Flusspfaden in dem wenigstens einen Messbereich ist es dementsprechend möglich, eine Vielzahl von Erregerwicklungen anzuordnen.

Die wenigstens eine Erregerwicklung ist dazu eingerichtet, mit hoher Frequenz, welche im zweistelligen kHz-Bereich liegen kann, periodisch einen magnetischen Fluss in den umwickelten Flusspfaden hervorzurufen und dazu äquivalent deren magnetischen Widerstand zu beeinflussen. Der magnetische Fluss in den Flusspfaden ist dabei bevorzugt geschlossen, das heißt im Vergleich der umwickelten Flusspfade weisen deren magnetische Flüsse beide jeweils den gleichen Betrag aber unterschiedliche Orientierungen auf. Durch die hohen Frequenzen wird ein Beitrag geleistet, sich sehr schnell ändernde Ströme des Primärleiters messen zu können. Die Erregerwicklung ist dazu eingerichtet, dass durch sie ein entsprechender Erregerstrom geleitet werden kann, welcher einen magnetischen Fluss in den von der Erregerwicklung umwickelten Flusspfad bzw. Flusspfaden hervorruft. Bevorzugt ist die Erregerwicklung dazu eingerichtet, die magnetische Sättigung des umwickelten Flusspfads bzw. der umwickelten Flusspfade herbeizuführen. Des Weiteren kann die wenigstens eine Erregerwicklung dazu eingerichtet sein, abwechselnd einen magnetischen Fluss unterschiedlicher Orientierung aber gleichen Betrags in dem wenigstens einen von ihr umwickelten Flusspfad hervorzurufen, wobei zwischen dem Wechsel der Orientierung des magnetischen Flusses stets eine Phase vorgesehen werden kann, in der kein magnetischer Fluss in dem Flusspfad hervorgerufen wird. Hierdurch können Remanenzeffekte reduziert werden. Die Erregerwicklung ermöglicht es auf besonders einfache Weise, den von ihr umwickelten Flusspfad bzw. die von ihr umwickelten Flusspfade magnetisch zu modulieren bzw. magnetisch zu sättigen, wobei gleichzeitig das Hervorrufen von unerwünschten Störflüssen in übrigen Teilen des Kerns vermieden werden kann, welcher die Messgenauigkeit herabsetzen und Offset-Fehler verursachen kann.

Um Teile des Kerns ist in dem Messbereich wenigstens eine Messwicklung gewickelt. Die Messwicklung kann beispielsweise um einen einzigen Flusspfad oder aber auch um mehrere Flusspfade des wenigstens einen Messbereichs gewickelt sein. Dabei ist es möglich, dass die Messwicklung um Flusspfade gewickelt ist, um die bereits eine Erregerwicklung gewickelt ist. Ebenfalls ist es vorgesehen, dass eine Messwicklung um einen oder mehrere Flusspfade gewickelt ist, um die keine Erregerwicklung gewickelt ist.

Die Messwicklung dient der Erfassung eines sich ändernden magnetischen Flusses in dem von der Messwicklung umwickelten Teil des Kerns. Zu diesem Zweck ist es möglich, in die Messwicklung, einen Wechselstrom bzw. eine Wechselspannung zu induzieren, welcher bzw. welche proportional zu der Änderung des magnetischen Flusses in dem von der Messwicklung umwickelten Teil des Kerns ist. Die Änderung des genannten magnetischen Flusses ist abhängig von der Differenz zwischen den induzierten magnetischen Flüssen des stromführenden Primärleiters und der Kompensationswicklung (Differenzfluss) und kann zur Regelung des Stromes der Kompensationswicklung genutzt werden. Verursacht wird die Änderung des magnetischen Flusses in dem von der Messwicklung umwickelten Flusspfad von der Erregung der wenigstens einen Erregerwicklung, welche ebenfalls Einfluss auf den Wert des magnetischen Flusses nimmt. Mit der erfindungsgemäßen Messwicklung kann Strom des stromführenden Primärleiters besonders genau ermittelt werden.

Die Wicklungszahl der Messwicklung ist frei wählbar, wobei mit steigender Anzahl an Windungen die Messgenauigkeit gesteigert werden kann.

In einer ersten Ausführungsform des erfindungsgemäßen Geräts zur Messung von Strom weist das Gerät einen Messbereich mit zwei den Messbereich in drei benachbarte Flusspfade teilenden Durchbrüchen, eine mit unterschiedlicher Orientierung um zwei Flusspfade gewickelte Erregerwicklung und eine um den übrigen Flusspfad gewickelte Messwicklung auf.

Die zwei Durchbrüche teilen den Messbereich des Kerns in drei benachbarte Flusspfade, wobei bevorzugt ein Flusspfad zwischen den Durchbrüchen verläuft und zwei weitere Flusspfade jeweils durch einen der Durchbrüche und einen inneren bzw. äußeren Rand des Kerns begrenzt werden. Um zwei der Flusspfade ist eine Erregerwicklung mit unterschiedlicher Orientierung gewickelt, womit durch sie auf besonders einfache Weise und besonders effektiv ein geschlossener magnetischer Fluss in den von ihr umwickelten Flusspfaden hervorgerufen werden kann. Dabei ist es möglich, dass die Erregerwicklung um zwei benachbarte Flusspfade gewickelt ist. Es ist jedoch ebenfalls vorgesehen, dass die Erregerwicklung um zwei Flusspfade gewickelt ist, welche nicht direkt benachbart sind, sondern zwischen denen sich der übrige Flusspfad befindet. Die Erregerwicklung verläuft entlang eines der beiden umwickelten Flusspfade in einer Wicklungsrichtung und entlang des anderen Flusspfads entgegengesetzt. Bevorzugt verläuft der Draht dabei größtenteils symmetrisch zu einem Punkt zwischen den Flusspfaden, in dem sich die Erregerwicklung selbst kreuzt. Die Erregerwicklung kann dabei entweder einfach oder mehrfach um die Flusspfade gewickelt sein, wobei es auch möglich ist, dass einer der Flusspfade häufiger umwickelt ist als der andere Flusspfad.

Die Erregerwicklung kann periodisch den magnetischen Widerstand des Paars an Flusspfaden verändern bzw. diese Flusspfade magnetisch sättigen. Dabei begünstigt der beschriebene Verlauf der Erregerwicklung um die zwei Flusspfade, dass im erregten Zustand der Erregerwicklung die Richtung des magnetischen Flusses des einen umwickelten Flusspfads entgegengesetzt aber mit gleicher Größe zu dem magnetischen Fluss des anderen umwickelten Flusspfads verläuft. Die Erregerwicklung ist dazu eingerichtet, den magnetischen Fluss, welcher der Differenz aus den magnetischen Flüssen entspricht, welche durch den Primärleiter und die Kompensationswicklung hervorgerufen worden sind, in dem Messbereich innerhalb des übrigen Flusspfades zu erhöhen (im erregten Zustand) und zu verringern (im nicht erregten Zustand). Diese Erhöhung bzw. Verringerung des magnetischen Flusses kann als Wechselstrom bzw. Wechselspannung in die Messwicklung induziert werden, wodurch auf vorstehend beschriebene Weise der Kompensationsstrom der Kompensationswicklung geregelt werden kann.

Die erste Ausführungsform des erfindungsgemäßen Geräts zur Messung von Strom zeichnet sich insbesondere dadurch aus, dass durch eine einzige Erregerwicklung in zwei Flusspfaden des Messbereichs des Kerns ein nahezu geschlossener magnetischer Fluss erzeugt werden kann, der in beiden Flusspfaden entgegengerichtet ist, aber den Gleichen Betrag aufweist. Im Idealfall gleichen sich die magnetischen Flüsse dadurch nach Außen hin aus und es wird durch die Erregerwicklung kein magnetischer Störfluss in anderen Bereichen des Magnetkerns hervorgerufen. Eine derartige Erregerwicklung weist den Vorteil auf, dass nur eine Stromquelle nötig ist, um die Erregerwicklungen zu erregen, und dass Aufwand für die Abstimmung der Ströme in zwei Erregerwicklungen entfallen kann. Bevorzugt weisen die von der Erregerwicklung umwickelten Flusspfade die gleiche Größe auf, wodurch auf besonders einfache Weise die Erregerwicklung symmetrisch geführt und ein nahezu geschlossener magnetischer Fluss in den von der Erregerwicklung umwickelten Flusspfaden erzielt werden kann.

In einer zweiten Ausführungsform des erfindungsgemäßen Geräts weist das Gerät zwei Messbereiche mit jeweils zwei die Messbereiche in drei benachbarte Flusspfade teilenden Durchbrüchen, zwei mit unterschiedlicher Orientierung um jeweils zwei Flusspfade der Messbereiche gewickelten Erregerwicklungen, eine um den übrigen Flusspfad eines der Messbereiche gewickelte Messwicklung und/oder eine um den übrigen Flusspfad des anderen Messbereichs gewickelte Messwicklung auf.

Diese zweite Ausführungsform weist zwei aufeinanderfolgende Messbereiche auf, welche einzeln betrachtet den Messbereichen der ersten Weiterbildung mit den vorgenannten Eigenschaften und Vorteilen entsprechen. Für die Funktionsfähigkeit des Geräts reicht bereits eine Messwicklung aus, wobei in der Ausführungsform mit zwei Messwicklungen diese in Reihe angeordnet sind und ein Ausgangssignal liefern können, welches im Vergleich zu der Ausführungsform mit einer Messwicklung eine bis zu doppelte Frequenz aufweist. Dies wirkt sich positiv auf die Reaktionszeit des Geräts zur Erfassung sich ändernder Primärströme aus. Die zweite Ausführungsform ist besonders dann von Vorteil, wenn die Erregerwicklungen abwechselnd erregt werden. Die Erregungen der Erregerwicklungen können dann derart aufeinander abgestimmt werden, dass wenn ein Strom durch die eine Erregerwicklung geleitet wird, durch die jeweils andere Erregerwicklung kein Strom geleitet wird. Dadurch kann auf besonders einfache Weise Rauschen, welches durch Störflüsse der Erregerwicklung im erregten Zustand verursacht wird, im Rest des Geräts unterdrückt werden.

In einer dritten Ausführungsform der Erfindung weist das Gerät zur Messung von Strom einen Messbereich mit drei den Messbereich in ein erstes Paar benachbarter Flusspfade und ein zweites Paar benachbarter Flusspfade teilenden Durchbrüchen und zwei mit unterschiedlicher Orientierung um jeweils ein Paar benachbarter Flusspfade gewickelte Erregerwicklungen auf.

Diese dritte Ausführungsform zeichnet sich dadurch aus, dass sämtliche Pfade des einen Messbereichs von zwei Erregerwicklungen umwickelt sind. Diese Anordnung ist besonders vorteilhaft, wenn die Erregerwicklungen abwechselnd erregt werden. Wie bei den vorstehend beschriebenen aufeinanderfolgenden Messbereichen kann die Erregung der Erregerwicklungen derart aufeinander abgestimmt werden, dass wenn ein Strom durch die eine Erregerwicklung geleitet wird, durch die jeweils andere Erregerwicklung kein Strom geleitet wird. Dadurch kann auf besonders einfache Weise Rauschen, welches durch Störflüsse der Erregerwicklung im erregten Zustand verursacht wird, im Rest des Geräts unterdrückt werden.

In einer ersten Weiterbildung der dritten Ausführungsform ist eine Messwicklung um das erste Paar benachbarter Flusspfade gewickelt und/oder eine Messwicklung um das zweite Paar benachbarter Flusspfade gewickelt. Bei der Ausführung mit zwei Messwicklungen teilen sich jeweils eine Erregerwicklung und eine Messwicklung zwei Flusspfade. Dadurch ist das Gerät in der Lage, bei abwechselnder Erregung der ersten und zweiten Erregerwicklung, den magnetischen Widerstand der Paare benachbarter Flusspfade abwechselnd magnetisch zu modulieren, indem deren magnetischer Widerstand bei einer Erregung verringert und bei Rückkehr in den nichterregten Zustand wieder erhöht wird, und die dadurch herbeigeführte Änderung des magnetischen Flusses in beiden Paaren benachbarter Flusspfade (bei zwei Messwicklungen) bzw. in einem Paar benachbarter Flusspfade (bei einer Messwicklung) zu erfassen. Für die Funktionsfähigkeit des Geräts ist bereits eine Messwicklung ausreichend. Bei Vorsehen von zwei Messwicklungen in der vorgenannten Weise können diese ein Ausgangssignal liefern, welches im Vergleich zu der Ausführungsform mit einer Messwicklung eine bis zu doppelte Frequenz aufweist. Dies wirkt sich positiv auf die Reaktionszeit des Geräts zur Erfassung sich ändernder Primärströme aus. Durch diese Weiterbildung ist es des Weiteren möglich, einen Messbereich mit vier Flusspfaden, zwei Erregerwicklungen und einer Messwicklung bzw. zwei Messwicklungen auf besonders platzsparende Weise an dem Kern anzuordnen.

Eine zweite Weiterbildung der dritten Ausführungsform zeichnet sich dadurch aus, dass der mittlere der drei Durchbrüche eine größere Ausdehnung hat als die Flusspfade und dadurch eine erste gemeinsame Verlängerung des ersten Paars benachbarter Flusspfade und eine zweite gemeinsame Verlängerung des zweiten Paars benachbarter Flusspfade definiert, eine Messwicklung um die erste gemeinsame Verlängerung gewickelt ist und/oder eine Messwicklung um die zweite gemeinsame Verlängerung gewickelt ist.

Die zwei Paare Flusspfade laufen jeweils in einem gemeinsamen Flusspfad, der sogenannten gemeinsamen Verlängerung, zusammen. Die gemeinsamen Verlängerungen sind durch den mittleren Durchbruch voneinander getrennt. Dadurch, dass die Messwicklung bzw. die Messwicklungen um eine gemeinsame bzw. um jeweils eine gemeinsame Verlängerung gewickelt ist bzw. sind, kann bzw. können die Erregerwicklung bzw. die Erregerwicklungen besonders gut von der Messwicklung bzw. den Messwicklungen beabstandet und somit die Gefahr verringert werden, dass die Erregerwicklungen unerwünscht Einfluss auf die Messwicklung bzw. die Messwicklungen nehmen. Hinsichtlich einer abwechselnden Erregung der Erregerwicklungen bei Vorsehen von einer Messwicklung oder von zwei Messwicklungen weist die zweite Weiterbildung der dritten Ausführungsform die gleichen Funktionalitäten und Vorteile auf wie die erste Weiterbildung der dritten Ausführungsform.

In einer weiteren Ausführungsform des Geräts zur Messung von Strom ist vorgesehen, dass die wenigstens eine Erregerwicklung mit einer Modulator-Einheit verbunden ist. Die mit der Erregerwicklung verbundene Modulator-Einheit dient als Stromquelle zum Hervorrufen des vorstehend beschriebenen magnetischen Flusses in den von der wenigstens einen Erregerwicklung umwickelten Flusspfaden, wobei entsprechende Ströme bevorzugt ausreichend hohe Werte annehmen können sollten, die zu einer magnetischen Sättigung der Flusspfade führen. Als Modulator-Einheit kann beispielsweise ein digitaler Frequenz-Generator vorgesehen sein.

Die Modulator-Einheit kann im einfachsten Fall dazu eingerichtet sein, einen Strom zu liefern, welcher periodisch ein- und ausschaltbar ist. Mittels eines solchen Ausgangssignals kann die Erregerwicklung derart betrieben werden, dass die Modulator-Einheit periodisch einen Strom durch die Erregerwicklung leitet, welcher mit der gleichen Frequenz einen magnetischen Fluss in den Flusspfaden hervorruft. Dadurch wird es ermöglicht, den magnetischen Widerstand der Flusspfade periodisch zu erhöhen und zu senken, wobei die Flusspfade bei ausreichend hohen Strömen periodisch magnetisch gesättigt werden können.

Ebenfalls ist der Einsatz einer Modulator-Einheit vorgesehen, welche einen rechteckigen oder trapezförmigen Strom mit abwechselnd positivem und negativem Strom gleichen Betrags liefern kann. Zwischen dem Wechsel von positivem auf negativen Strom und umgekehrt ist stets eine Phase, welche bevorzugt stets die gleiche Dauer haben sollte, vorgesehen, in welcher die Modulator-Einheit kein Stromsignal aussendet und in der durch die Erregerwicklung kein Strom fließen sollte. Die Modulator-Einheit ist dazu eingerichtet, einen entsprechenden rechteckigen oder trapezförmigen Strom durch die Erregerwicklung zu leiten, welcher im Takt des Vorzeichenwechsels des genannten Stroms einen zu diesem proportionalen magnetischen Fluss abwechselnder Orientierung aber gleichen Betrags in den Flusspfaden hervorruft. Dieser wechselnde magnetische Fluss ist besonders gut dafür geeignet, Remanenzeffekte in den Flusspfaden und Rauschen im Rest des Geräts zu verringern. Die vorstehend beschriebenen Funktionalitäten und Vorteile sind auch mit Modulator-Einheiten zu erreichen, welche Ströme anderer Form liefern, z.B. dreieckförmige oder sinusförmige Ströme.

Die Modulator-Einheit kann beispielsweise eine Stromquelle zur Aussendung der vorstehend beschriebenen Stromsignale und einen mit der Stromquelle verbundenen und diese steuernden Modulator aufweisen. Der Modulator kann beispielsweise in die Modulator-Einheit integriert oder als externer Modulator mit der Stromquelle verbunden sein. Der Modulator sollte insbesondere dazu eingerichtet sein, zu steuern, welches Ausgangssignal die Modulator-Einheit liefert. Dadurch ist es in besonders flexibler Weise möglich, sowohl die Stromquelle als auch andere Elemente des Geräts zur Messung von Strom gemeinsam durch den Modulator zu steuern oder zu synchronisieren.

Vorteilhaft ist weiterhin vorgesehen, dass ein Demodulator mit der wenigstens einen Messwicklung verbunden und mit der Modulator-Einheit synchronisierbar ist. Der Demodulator leistet einen Beitrag zur Bereitstellung des Kompensationsstromes in der Kompensationswicklung. Durch den Demodulator kann der in die Messwicklung induzierte Wechselstrom empfangen, verändert und ausgegeben werden. So kann ein Demodulator, z.B. in Form eines analogen Umkehrschalters, vorgesehen sein, welcher dazu eingerichtet ist, einzelne Phasen des Wechselstromes zu invertieren, sodass der Demodulator im Sinne eines Gleichrichters wirkt. Der Demodulator ist mit der Modulator-Einheit synchronisierbar, d.h. die zeitliche Steuerung der Modulator-Einheit ist auf den Demodulator in seiner betreffenden Funktion übertragbar. Somit kann das Hervorrufen magnetischen Flusses in den durch die wenigstens eine Erregerwicklung umwickelten Flusspfaden auf den Betrieb des Demodulators abgestimmt werden. Der Demodulator und der Demodulator können dafür in besonders praktischer Weise miteinander verbunden sein. Die Synchronisation kann jedoch auch auf anderem Wege erfolgen, ohne dass eine Verbindung zwischen dem Demodulator und der Modulator-Einheit nötig ist.

Weiterhin ist es vorteilhaft, wenn ein Integrator mit dem Demodulator verbunden ist. Der Integrator ist dazu eingerichtet von dem Demodulator ausgegebene Signale zu empfangen, sie zu integrierend zu verändern und sie auszugeben. Der Integrator kann beispielsweise in Form eines Gleichrichters mit parallelem Kondensator (zur Glättung) vorgesehen sein. Der Integrator kann in diesem Fall dazu eingerichtet sein, ein von dem Demodulator empfangenes Wechselstromsignal in ein Gleichstromsignal umzuwandeln. Der Integrator kann außerdem als Tiefpassfilter dienen. Durch den Integrator kann eine besonders genaue Regelung des Kompensationsstromes der Kompensationswicklung erreicht werden.

Des Weiteren ist es vorteilhaft, wenn ein erster Operationsverstärker mit der Kompensationswicklung und einem Ausgang verbunden ist. Durch den ersten Operationsverstärker kann der Kompensationsstrom der Kompensationswicklung fließen und in eine dem Kompensationsstrom proportionale Ausgangsspannung umgewandelt werden. Bevorzugt ist dazu in einer Rückkopplungsschleife ein Widerstand vorgesehen, welcher das Umwandlungsverhältnis bestimmt. Durch den ersten Operationsverstärker können hochfrequente (gemessene) Signale des Primärleiters ausgeglichen werden. Alternativ kann der Ausgang auch direkt mit der Kompensationswicklung verbunden sein, sodass auf besonders einfache Weise der Kompensationsstrom an dem Ausgang direkt abgenommen werden kann.

Von Vorteil ist es weiterhin, wenn der Integrator mit der Kompensationswicklung verbunden ist. Dadurch kann der Gleichstrom des Integrators auf besonders einfache Weise der Kompensationswicklung zugeführt werden. Der Gleichstrom entspricht dann dem Kompensationsstrom, mittels dessen der Null-Fluss-Zustand in dem Kern erreicht werden kann. Hiermit wird ein Beitrag dazu geleistet, Remanenzeffekte im Kern zu verringern.

Weiterhin ist vorteilhaft vorgesehen, dass der Integrator mit einem zweiten Operationsverstärker verbunden ist, welcher mit der Kompensationswicklung und dem ersten Operationsverstärker verbunden ist. Durch den zweiten Operationsverstärker kann der Spannungsabfall - verursacht durch den Widerstand der Kompensationswicklung - ausgeglichen werden. Des Weiteren ist der Einsatz mehrerer sehr dünner Windungen möglich, wodurch das Gerät kleiner dimensioniert werden kann. Außerdem können Windungen eingesetzt werden, welche einen höheren Widerstand aufweisen, was durch den zweiten Operationsverstärker durch eine entsprechend verstärkte Spannung ausgeglichen werden kann. Durch die Kombination des ersten und zweiten OperationsVerstärkers kann ein Betrieb des Geräts in einer hohen Frequenz-Bandweite erreicht werden, z.B. zwischen einem Bereich von 0,1 Hz bis in den MHz-Bereich. Eine Verwendung der bereits für sich genommenen nicht naheliegenden Verbindung des ersten und zweiten Operationsverstärkers sowie des Integrators ist auch - mit ähnlichen oder gleichen Vorteilen - denkbar, wenn dem Integrator durch andere als vorstehend beschriebene Mittel ein Signal zugeführt wird.

Gemäß einer weiteren vorteilhaften Ausführungsform ist vorgesehen, dass die Messwicklung einen Analog/Digital-Wandler umfasst. Der Analog/Digital-Wandler kann beispielsweise an ein Ende der Messwicklung angeschlossen und mit dem Demodulator verbunden sein. Der Analog/Digital-Wandler ist dazu eingerichtet, die von der Messwicklung erfassten Änderungen des magnetischen Flusses in digitale Signale zu wandeln und dem an die Messwicklung angeschlossenen Demodulator und dadurch auch dem Integrator und den Operationsverstärkern zur Verfügung zu stellen. Somit ist es möglich, den Kompensationsstrom durch digitale Regelungstechnik einzustellen und Temperaturdrifts, welche durch die analoge Ausführung hervorgerufen werden können, zu vermieden. In diesem Zusammenhang ist weiterhin besonders vorteilhaft vorgesehen, den Demodulator komplett digital zu implementieren. Ebenfalls kann vorteilhaft vorgesehen sein, anstatt des Integrators einen Rückkopplungs-Regler, beispielsweise einen PI-Regler oder einen PID-Regler einzusetzen.

Besonders vorteilhaft ist weiterhin vorgesehen, dass der erste Operationsverstärker und der zweite Operationsverstärker zusammen digital und analog implementiert werden. Beispielsweise kann eine vollbrückenartige digitale Endstufe vorgesehen werden, welche beide Enden der Kompensationswicklung mit analogen Rückkopplungs-Operationsverstärkern betreibt. Durch die Rückkopplung kann die Spannung bzw. die Stromstärke in der Kompensationswicklung dem digitalen Teil der Operationsverstärker zur Regelung der digitalen Abgabe rückgeführt werden.

Das Verfahren zur Ermittlung von Strom unter Verwendung eines der vorstehend beschriebenen Geräte zur Messung von Strom umfasst die Verfahrensschritte
- Leiten eines Primärstromes durch den Primärleiter und dadurch Hervorrufen eines magnetischen Flusses in dem Kern;
- Leiten eines Kompensationsstromes durch die Kompensationswicklung und dadurch Hervorrufen eines magnetischen Flusses in den Kern, um dem durch den Primärleiter hervorgerufenen magnetischen Fluss entgegenzuwirken;
- Periodisches Erregen der wenigstens einen Erregerwicklung und dadurch, sofern erregt, Hervorrufen eines magnetischen Flusses in wenigstens zwei von der wenigstens einen Erregerwicklung umwickelten Flusspfaden und dadurch magnetisches Modulieren genannter Flusspfade;
- Erfassen der Änderung des magnetischen Flusses mittels der wenigstens einen Messwicklung zwischen verschiedenen Erregungszuständen der Erregerwicklung zur Ableitung eines Demodulations-Signals zur Regelung des durch die Kompensationswicklung hervorgerufenen magnetischen Flusses;
- Einstellen des Kompensationsstromes auf einen Wert, so dass die durch die Messwicklung erfasste Änderung des magnetischen Flusses minimiert ist;
- Messen des Kompensationsstromes;
- Berechnen des Primärstromes aus dem Kompensationsstrom.

Durch den Primärleiter kann ein Strom, der sogenannte Primärstrom, geleitet werden. Der Primärstrom soll durch das Verfahren zur Ermittlung von Strom mittels eines Geräts zur Messung von Strom ermittelt werden. Die Unterscheidung zwischen Messung und Ermittlung erfolgt deshalb, weil der Primärstrom im Rahmen des Verfahrens nicht direkt gemessen wird, sondern aus dem Kompensationsstrom berechnet werden kann.

Der Primärstrom ruft in dem Kern einen zu dem Primärstrom proportionalen magnetischen Primärfluss hervor, dem ein magnetischer Kompensationsfluss entgegenwirkt, welcher durch die Kompensationswicklung in dem Kern hervorgerufen wird. Dazu wird ein entsprechender Kompensationsstrom durch die Kompensationswicklung geleitet. Die Differenz zwischen Primärstrom und Kompensationsstrom ergibt einen Differenzstrom, welcher einem magnetischen Differenzfluss in dem Kern entspricht. Wenn sich das Gerät im Null-Fluss-Zustand befindet, bei dem der Primärfluss durch den Kompensationsfluss ausgeglichen wird, wird keine Energie des stromführenden Primärleiters verbraucht.

Die wenigstens eine Erregerwicklung wird periodisch erregt. Erregt wird die Erregerwicklung, indem durch sie ein Erregerstrom geleitet wird. Als Erregerströme kommen neben unipolaren auch insbesondere solche bipolaren Erregerströme in Betracht, welche zeitlich symmetrisch verlaufen, einen Mittelwert von Null haben und zwischen dem Vorzeichenwechsel eine bevorzugt stets gleich lange Phase aufweisen, in der kein Erregungssignal erzeugt wird. Beispiele für geeignete bipolare Erregungen sind Erregerströme mit rechteckigem, trapezförmigem dreieckförmigem oder sinusförmigem Verlauf.

Die periodische Erregung kann durch die Modulator-Einheit wie vorstehend beschrieben beispielsweise in folgender Weise unipolar erregt werden: Die Erregung besteht aus zwei Phasen, wobei in einer Phase ein Gleichstromsignal durch die Erregerwicklung geleitet wird, und in der zweiten Phase kein Strom durch die Erregerwicklung geleitet wird. Hierbei können alle Phasen die gleiche Dauer aufweisen. Das Gleichstromsignal weist in jeder erregten Phase die gleiche Orientierung und Amplitude auf. In die von der Erregerwicklung umwickelten Flusspfade wird durch das Gleichstromsignal ein zu diesem proportionaler magnetischer Fluss hervorgerufen, welcher den magnetischen Widerstand der Flusspfade moduliert. Mit einer Erhöhung des magnetischen Flusses kann somit die magnetische Leitfähigkeit der Flusspfade herabgesetzt werden, was bei Einleitung entsprechend großer Ströme bis zu der magnetischer Sättigung der Flusspfade führen kann. Mit entsprechend angepasstem Verlauf des magnetischen Flusses in den Flusspfaden ist es ebenfalls möglich, die Erregerwicklung periodisch mit einem Stromsignal zu erregen, welches in jeder erregten Phase die gleiche Amplitude aber entgegengesetzte Orientierung und zwischen dem Vorzeichenwechsel eine bevorzugt gleich lange Phase mit keiner Erregung aufweist (bipolare Erregung).

Wenn die Erregerwicklung nicht erregt ist, verteilt sich der Differenzfluss auf alle Flusspfade des wenigstens einen Messbereichs. Befindet sich die Erregerwicklung im erregten Zustand, so steigt der magnetische Fluss in den Flusspfaden, welche zu diesem Zeitpunkt nicht durch eine Erregerwicklung magnetisch moduliert sind, weil die magnetische Leitfähigkeit der magnetisch modulierten Flusspfade herabgesetzt wird. Bei Rückkehr in den nicht erregten Zustand verteilt sich der Differenzfluss wieder auf alle Flusspfade und der magnetische Fluss in dem zuvor nicht magnetisch modulierten Flusspfad sinkt wieder.

Wenn ein realisierter Kern von dem beschriebenen theoretischen Aufbau abweicht, so kann ein Störsignal (in Form einer Wechselspannung oder eines Wechselstroms) entstehen, welches proportional zu dem Erregerstrom ist und dem in die Messwicklung induzierten Strom überlagert wird.

Die Änderung des magnetischen Flusses wird in Teilen des Messbereichs mittels der wenigstens einen Messwicklung erfasst. Unter Erfassen ist zu verstehen, dass in die Messwicklung ein Messsignal in Form einer Wechselspannung bzw. eines Wechselstroms induziert wird. Das Messsignal ist proportional zu der Änderung des magnetischen Flusses in dem von der Messwicklung umwickelten Teil des Messbereichs zwischen verschiedenen Erregungszuständen. Die Frequenz der Wechselspannung bzw. des Wechselstroms entspricht der Frequenz der Erregung der Erregerwicklungen. Aus dem Messsignal wird ein demoduliertes Signal abgeleitet, mit dem der Kompensationsstrom, welcher durch die Kompensationswicklung geleitet wird, geregelt werden kann, wodurch der dem Primärfluss entgegenwirkende Kompensationsfluss in dem Kern hervorrufen wird. Der Kompensationsstrom wird derart geregelt, dass die Änderung des durch die wenigstens eine Messwicklung erfassten magnetischen Flusses gegen Null geht.

Die Regelung des Kompensationsstroms kann dadurch geschehen, dass Letzterer durch das in die Messwicklung induzierte Messsignal eine Rückmeldung erhält, aufgrund derer der Kompensationsstrom nachgeregelt wird. Erreicht werden soll, dass sich der magnetische Fluss in dem von der Messwicklung umwickelten Teil des Messbereichs nicht ändert (Soll-Wert). Wenn dies der Fall ist, dann ist in dem Kern der Null-Fluss-Zustand erreicht. Der tatsächliche Wert der Änderung des magnetischen Flusses wird über das Messsignal bereitgestellt (Ist-Wert).

Schließlich kann der Kompensationsstrom bzw. eine zu diesem proportionale Spannung durch geeignete Mittel wie beispielsweise Strom- oder Spannungsmessgeräte oder Rechnereinheiten gemessen und der Primärstrom ermittelt werden.

Im Rahmen des erfindungsgemäßen Verfahrens ist besonders vorteilhaft vorgesehen, zwei Erregerwicklungen, welche um jeweils zwei Flusspfade gewickelt sind, entgegengesetzt zu betreiben. Dieses Verfahren bietet sich an, wenn die Erregerwicklungen unipolar oder bipolar betrieben werden. Die Erregung der Erregerwicklungen kann dann derart aufeinander abgestimmt werden, dass wenn ein Strom durch die eine Erregerwicklung geleitet wird, durch die jeweils andere Erregerwicklung kein Strom geleitet wird. Dadurch kann auf besonders einfache Weise Rauschen, welches durch Störflüsse der Erregerwicklung im erregten Zustand verursacht wird, im Rest des Geräts unterdrückt werden.

Weiterhin ist es vorteilhaft, die Enden der Messwicklung mittels des Demodulators abwechselnd mit dem Eingang des Integrators zu verbinden. Auf diese Weise können die Phasen des Messsignals, welches in die Messwicklung induziert wird, besonders einfach invertiert werden, sodass der Demodulator im Sinne eines Gleichrichters wirkt. In einer weiteren vorteilhaften Weiterbildung dieses Verfahrens ist der Demodulator mit der Modulator-Einheit synchronisiert. Der Demodulator und die Modulator-Einheit sind dann mit der gleichen Frequenz betreibbar. Der Demodulator erfüllt dann die Funktion eines von der Modulator-Einheit gesteuerten Multiplizierers, der das Messsignal der Messwicklung moduliert.

Des Weiteren ist vorteilhaft vorgesehen, dass das Ausgangssignal des Demodulators mittels des Integrators in den Kompensationsstrom umgewandelt wird. Der Integrator empfängt das von dem Demodulator ausgegebene Signal und wandelt es in einen Gleichstrom um, welcher als Kompensationsstrom in die Kompensationswicklung eingeleitet wird. Der auf diese Weise erzeugte Kompensationsstrom zeichnet sich durch eine besonders hohe Genauigkeit aus.

Außerdem ist es vorteilhaft, wenn das Ausgangssignal des Demodulators mittels des Integrators und des zweiten Operationsverstärkers, welcher ein Rückkopplungssignal von dem ersten Operationsverstärker empfängt, in den Kompensationsstrom umgewandelt wird. Hierdurch kann der durch den Widerstand der Kompensationswicklung verursachte Spannungsabfall ausgeglichen und durch das Herabsetzen der Bandweite auf wenige Hz oder weniger weiterhin die Messgenauigkeit erhöht werden.

Eine weitere vorteilhafte Ausführungsform des erfindungsgemäßen Verfahrens ist gekennzeichnet durch Messen der Induktivität der wenigstens einen Erregerwicklung und Erzeugen eines Signals, welches anzeigt, ob die jeweils gemessene Induktivität in einem bestimmten Bereich liegt oder nicht. Aufgrund ihrer Induktivität kann beispielsweise wenn der durch die Erregerwicklung fließende Strom gewechselt oder verändert wird, ein Spannungsanteil in der Erregerwicklung erfasst werden, wobei der Wert der Induktivität von der Permeabilität des Kerns abhängig ist. Die Permeabilität verändert sich entgegen dem magnetischen Fluss in dem Kern, so dass es möglich ist, eine magnetische Sättigung des Kerns zu erfassen, welche zu einer inkorrekten und daher außerhalb eines zulässigen Bereichs liegenden Verfolgung des Primärstroms führt. Der Spannungsanteil kann z.B. durch einen Komparator ermittelt werden, welcher die Differenz zwischen einer Referenzspannung (nämlich die Spannung, welche an die Erregerwicklung durch die Modulator-Einheit angelegt ist) und der Spannung, welche durch die Erregerwicklung aufgrund des restlichen magnetischen Flusses (nämlich erzeugt durch den Primärstrom) und abhängig von Letzterem im Kern induziert wird. Der Spannungsanteil kann als Indikator für die Kompensation des Primärstroms durch den Indikatorstroms genutzt werden. Dabei kann der bestimmte Bereich akzeptable Werte für ermittelte Spannungsanteile umfassen. Das Signal kann beispielsweise ein von anderen Geräten lesbares Ausgangssignal oder eine optische Anzeige sein, welche in einem besonders einfachen Fall zwei verschiedene Zustände anzeigen kann, nämlich dass ein jeweils gemessener Induktivitätswert in einem bestimmten Bereich liegt oder nicht.

Und schließlich betrifft die vorliegende Erfindung auch einen magnetischen Schalter eines magnetischen Kerns mit einem Messbereich, der wenigstens zwei Durchbrüche aufweist, welche den Messbereich in wenigstens drei benachbarte Flusspfade teilen, umfassend wenigstens eine Erregerwicklung, welche mit einer Modulator-Einheit verbunden ist. Entweder sind in dem Messbereich zwei einzelne Erregerwicklungen um jeweils einen einzelnen Flusspfad gewickelt oder eine Erregerwicklung ist in dem Messbereich um zwei Flusspfade gewickelt. Die wenigstens eine Erregerwicklung ist mittels der Modulator-Einheit periodisch erregbar, um, sofern erregt, einen magnetischen Fluss in den zwei von der wenigstens einen Erregerwicklung umwickelten Flusspfaden hervorzurufen.

Die mit der Modulator-Einheit verbundene Erregerwicklung stellt einen magnetischer Schalter dar, welcher den Flusspfad bzw. die Flusspfade für magnetischen Fluss öffnen und schließen kann. Wird die Erregerwicklung durch die Modulator-Einheit erregt, so dass sie einen magnetischen Fluss in dem Flusspfad bzw. in den Flusspfaden hervorruft, welcher zu dessen bzw. deren magnetischer Sättigung führt, so gilt der magnetische Schalter als geöffnet. Wird die Erregerwicklung nicht erregt, so ruft sie keinen magnetischen Fluss in dem Flusspfad bzw. in den Flusspfaden hervor, dieser bzw. diese werden nicht magnetisch gesättigt und der magnetische Schalter gilt als geschlossen. In einer besonders vorteilhaften Ausführungsform des magnetischen Schalters ist eine Erregerwicklung mit unterschiedlicher Orientierung um die zwei Flusspfade gewickelt. Bezüglich weiterer Vorteile und bevorzugter Weiterbildung des erfindungsgemäßen magnetischen Schalters gelten ersichtlich alle bereits in Zusammenhang mit dem erfindungsgemäßen Gerät erläuterten Aspekte, so dass zur Vermeidung von Wiederholungen hierauf verwiesen wird.

Nachfolgend werden Ausführungsbeispiele der Erfindung anhand der Zeichnung näher erläutert. Dabei zeigt:
- Fig. 1: eine schematische perspektivische Ansicht eines erfindungsgemäßen Geräts zur Messung von Strom mit zwei in einem Messbereich angeordneten Durchbrüchen, zwei um jeweils einen Flusspfad gewickelten Erregerwicklungen und einer um einen dritten Flusspfad gewickelten Messwicklung,
- Fig. 2: eine schematische perspektivische Ansicht einer ersten Ausführungsform eines erfindungsgemäßen Geräts zur Messung von Strom mit einer mit unterschiedlicher Orientierung um zwei Flusspfade gewickelten Erregerwicklung und einer um einen dritten Flusspfad gewickelten Messwicklung,
- Fig. 3: eine schematische perspektivische Ansicht einer zweiten Ausführungsform eines erfindungsgemäßen Geräts zur Messung von Strom mit zwei aufeinanderfolgenden Messbereichen,
- Fig. 4: eine schematische perspektivische Ansicht einer dritten Ausführungsform eines erfindungsgemäßen Geräts zur Messung von Strom mit drei in einem Messbereich angeordneten Durchbrüchen und zwei um gemeinsame Verlängerungen von Flusspfaden gewickelten Messwicklungen,
- Fig. 5: einen schematischen Schaltplan einer weiteren Ausführungsform eines erfindungsgemäßen Geräts zur Messung von Strom,
- Fig. 6: einen schematischen Schaltplan einer der Ausführungsform gemäß Fig. 5 ähnlichen Ausführungsform ohne zweiten Operationsverstärker,
- Fig. 7: einen schematischen Schaltplan einer der Ausführungsform gemäß Fig. 6 ähnlichen Ausführungsform zur direkten Ausgabe des Kompensationsstromes und
- Fig. 8: einen schematischen Schaltplan einer weiteren Ausführungsform des erfindungsgemäßen Geräts zur Messung von Strom mit einem Analog/Digital-Wandler und alternativ ausgestalteten Operationsverstärkern.

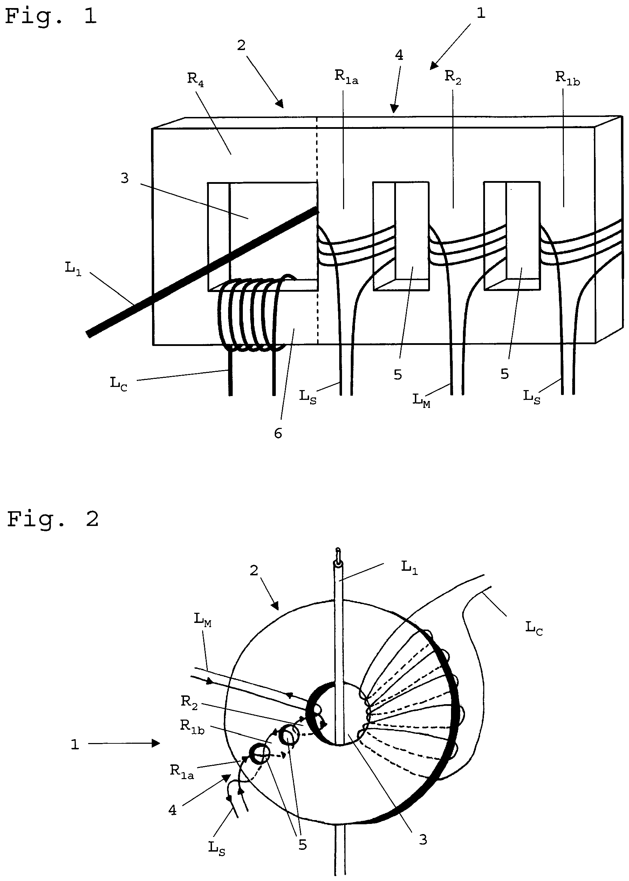

Das in Fig. 1 dargestellte erfindungsgemäße Gerät 1 zur Messung von Strom weist einen geschlossenen magnetischen und im Ganzen quaderförmigen Kern 2 mit einem Durchbruch 3 auf, durch den ein Primärleiter L₁ verläuft. In einem Messbereich 4 sind zwei Durchbrüche 5 angeordnet, welche den Messbereich 4 in drei benachbarte Flusspfade R₁ₐ, R_{1b}, R₂ teilen. Zur Verdeutlichung seiner Ausdehnung ist der Messbereich 4 in Fig. 1 durch eine Strichlinie von dem Rest des Kerns abgetrennt. Eine Kompensationswicklung L_{c} ist außerhalb des Messbereichs 4 um einen Schenkel 6 des Kerns 2 gewickelt. Zwei Erregerwicklungen Lₛ sind um zwei Flusspfade R₁ₐ, R_{1b} und eine Messwicklung L_{M} um den übrigen Flusspfad R₂ gewickelt.

Die in Fig. 2 dargestellte erste Ausführungsform eines erfindungsgemäßen Geräts 1 zur Messung von Strom weist einen geschlossenen magnetischen und im Ganzen ringförmigen Kern 2 auf, durch den ein Primärleiter L₁ verläuft. In einem Messbereich 4 sind zwei Durchbrüche 5 angeordnet, welche den Messbereich 4 in drei benachbarte Flusspfade R₁ₐ, R_{1b}, R₂ teilen. Eine Kompensationswicklung L_{C} ist außerhalb des Messbereichs 4 um den Kern 2 gewickelt. Eine einzige Erregerwicklung L_{S} ist mit unterschiedlicher Orientierung um zwei Flusspfade R₁ₐ, R_{1b} und eine Messwicklung um den übrigen Flusspfad R₂ gewickelt.

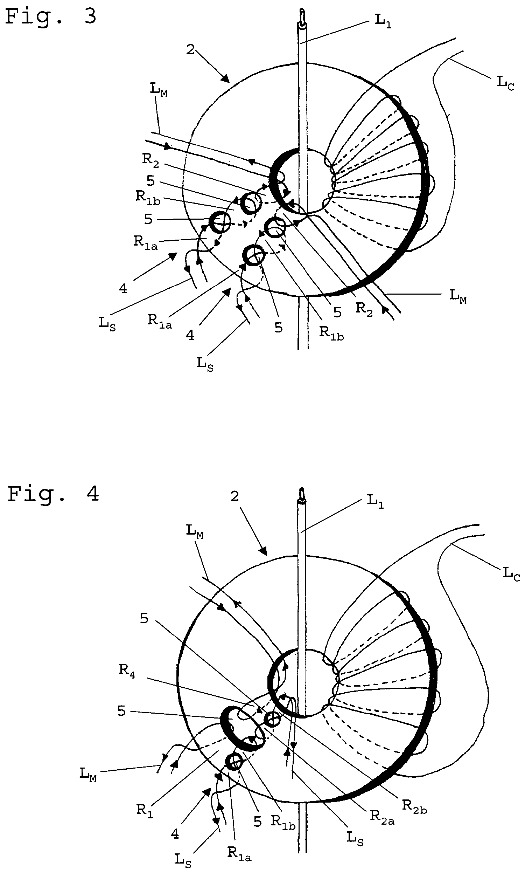

Die in Fig. 3 dargestellte zweite Ausführungsform eines erfindungsgemäßen Geräts 1 zur Messung von Strom weist einen geschlossenen magnetischen und im Ganzen ringförmigen Kern 2 auf, durch den ein Primärleiter L₁ verläuft. In zwei gleichartigen Messbereichen 4 sind jeweils zwei Durchbrüche 5 angeordnet, welche die Messbereiche 4 in jeweils drei benachbarte Flusspfade R₁ₐ, R_{1b}, R₂ teilen. Zwei Erregerwicklungen L_{S} sind zur entgegengesetzten Erregung mit unterschiedlicher Orientierung um jeweils zwei Flusspfade R₁ₐ, R_{1b} und zwei Messwicklungen L_{M} um den jeweils übrigen Flusspfad R₂ der Messbereiche 4 gewickelt.

Die in Fig. 4 dargestellte dritte Ausführungsform eines erfindungsgemäßen Geräts 1 zur Messung von Strom weist einen geschlossenen magnetischen und im Ganzen ringförmigen Kern 2 auf, durch den ein Primärleiter L₁ verläuft. In einem Messbereich 4 sind drei Durchbrüche 5 angeordnet, welche den Messbereich 4 in ein erstes Paar benachbarter Flusspfade R₁ₐ, R_{1b} und ein zweites Paar benachbarter Flusspfade R₂ₐ, R_{2b} teilen. Jeweils eine Erregerwicklungen L_{S} ist mit unterschiedlicher Orientierung um das erste Paar benachbarter Flusspfade R₁ₐ, R_{1b} und das zweite Paar benachbarter Flusspfade R₂ₐ, R_{2b} zur entgegengesetzten Erregung gewickelt. Der mittlere der drei Durchbrüche 5 weist eine größere Ausdehnung als die Flusspfade R₁ₐ, R_{1b}, R₂ₐ, R_{2b} auf und definiert dadurch eine erste gemeinsame Verlängerung R₁ des ersten Paars benachbarter Flusspfade R₁ₐ, R_{1b} und eine zweite gemeinsame Verlängerung R₄ des zweiten Paars benachbarter Flusspfade R₂ₐ, R_{2b}. Jeweils eine Messwicklung L_{M} ist um die erste gemeinsame Verlängerung R₁ und die zweite gemeinsame Verlängerung R₄ gewickelt.

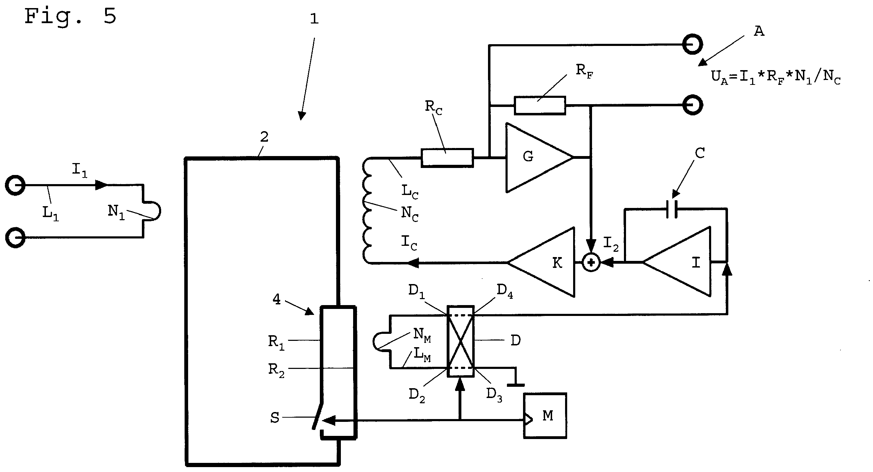

Der in Fig. 5 dargestellte Schaltplan einer weiteren Ausführungsform eines Geräts 1 zur Messung von Strom zeigt eine Primärwicklung in Form eines Primärleiters L₁, welcher einen Primärstrom I₁ führen kann und eine Windung N₁ aufweist. Der Primärleiter L₁ ruft, sofern er einen Primärstrom I₁ führt, einen zu diesem proportionalen magnetischen Primärfluss φ₁ in einem geschlossenen magnetischen Kern 2 hervor. Um den Kern 2 ist eine Kompensationswicklung L_{C} mit einer Vielzahl an Windungen N_{C}, welche einen Gesamtwiderstand R_{C} aufweisen, gewickelt. Durch die Kompensationswicklung L_{C} fließt ein Kompensationsstrom I_{C}, welcher einen magnetischen Kompensationsfluss φ_{C} in dem Kern hervorruft, welcher dem Primärfluss φ₁ entgegenwirkt. Die Differenz zwischen Primärfluss φ₁ und Kompensationsfluss φ_{C} ist der Differenzfluss Δφ, die Differenz zwischen Primärstrom I₁ und Kompensationsstrom I_{C} der Differenzstrom ΔI.

Der Kern 2 teilt sich in einem Messbereich 4 in drei Flusspfade R₁, R₂, wobei einer der Flusspfade R₁ aus zwei nicht dargestellten Flusspfaden R₁ₐ, R_{1b} besteht. Eine Erregerwicklung ist - wie zum Beispiel in Fig. 2 dargestellt - mit unterschiedlicher Orientierung um die zwei Flusspfade R₁ₐ, R_{1b} gewickelt und mit einer Modulator-Einheit M verbunden. Die Modulator-Einheit M ist dazu eingerichtet, die Erregerwicklung periodisch zu erregen, wobei letztere im erregten Zustand einen magnetischen Fluss in den Flusspfaden R₁ₐ, R_{1b} hervorruft, durch welchen die Flusspfade R₁ₐ, R_{1b} magnetisch gesättigt werden. Die Erregerwicklung ist ein magnetischer Schalter S, welcher die Flusspfade R₁ₐ, R_{1b} für magnetischen Fluss öffnen und schließen kann. Wird die Erregerwicklung erregt, so dass sie einen magnetischen Fluss in den Flusspfaden R₁ₐ, R_{1b} hervorruft, welcher zu deren magnetischer Sättigung führt, so gilt der magnetische Schalter S als geöffnet. Wird die Erregerwicklung nicht erregt, so ruft sie keinen magnetischen Fluss in den Flusspfaden R₁ₐ, R_{1b} hervor, diese werden nicht magnetisch gesättigt und der magnetische Schalter S gilt als geschlossen.

Eine Messwicklung L_{M} ist mit mehreren Windungen N_{M} um den Flusspfad R₂ gewickelt. In die Messwicklung L_{M} wird durch periodisches Öffnen und Schließen des magnetischen Schalters (gleichbedeutend mit einer periodischen Erregung der Erregerwicklung) ein Messsignal in Form einer Wechselspannung bzw. eines Wechselstroms induziert. Wenn noch kein Kompensationsstrom I_{C} durch die Kompensationswicklung L_{C} geleitet wird, so entspricht der Differenzfluss Δφ dem Primärfluss φ₁. Das Messsignal ist dann proportional zu dem Primärstrom I₁. Wird ein Kompensationsstrom I_{C} durch die Kompensationswicklung L_{C} geleitet, so ist das Messsignal proportional zu dem Differenzstrom ΔI.

Fig. 5 zeigt eine sehr einfache Ausführung eines Demodulators D in Form eines analogen Umkehrschalters. Das Messsignal der Messwicklung L_{M} wird zwei Eingängen D₁, D₂ des Demodulators D zugeführt, welcher außerdem über zwei Ausgänge D₃, D₄ verfügt. Der Demodulator wandelt das Messsignal in ein demoduliertes Signal um. Der Demodulator ist zwischen zwei Schaltstellungen abwechselnd schaltbar. In einer ersten Schaltstellung ist der Eingang D₁ mit dem Ausgang D₄ und der Eingang D₂ mit dem Ausgang D₃, dessen Signal einem Bezugssignal (Masse) zugeführt wird, verbunden. In einer zweiten Schaltstellung ist der Eingang D₁ mit dem Ausgang D₃ und der Eingang D₂ mit dem Ausgang D₄ verbunden. Die Frequenz, in welcher der Demodulator D die Schaltstellungen wechselt, ist synchronisiert mit der Erregungsfrequenz der Modulator-Einheit M. Durch die Schaltung des Demodulators D werden die Phasen des Messsignals derart invertiert, dass ein demoduliertes Signal von dem Demodulator D ausgegeben wird, welches größtenteils ein gleiches Vorzeichen aufweist.

Der Ausgang D₄ ist verbunden mit dem Eingang eines Integrators I, in dessen Rückkopplungsschleife ein Kondensator C angeordnet ist. Der Integrator I dient als Tiefpassfilter. Das Ausgangssignal des Integrators I ist ein Gleichstrom I₂, welcher durch einen ersten Operationsverstärker G und einen zweiten Operationsverstärker K in einen Kompensationsstrom I_{C} umgewandelt wird. Der erste Operationsverstärker G, der einen Widerstand R_{F} in seiner Rückkopplungsschleife aufweist, ist mit einem Ende der Kompensationswicklung L_{C} verbunden und hat den Verstärkungsfaktor G. Der zweite Operationsverstärker K hat einen Verstärkungsfaktor K und ist mit dem anderen Ende der Kompensationswicklung C und dem Ausgang des Integrators I verbunden. Der Gleichstrom I₂ wird von dem Ausgangssignal des ersten Operationsverstärkers G überlagert und anschließend durch den Operationsverstärker K mit dessen Verstärkungsfaktor K verstärkt.

Schließlich weist das Gerät 1 einen Ausgang A auf, an dessen Klemmen eine Ausgangsspannung U_{A} anliegt, welche proportional zu dem Primärstrom I₁ des stromführenden Primärleiters L₁ ist. Die Ausgangsspannung U_{A} hat den Wert U_{A} = I₁ * R_{F} * N₁/N_{C}. Mittels der Ausgangsspannung U_{A} kann der Primärstrom I₁ durch Anschließen geeigneter (nicht dargestellter) Mittel gemessen, berechnet und angezeigt werden.

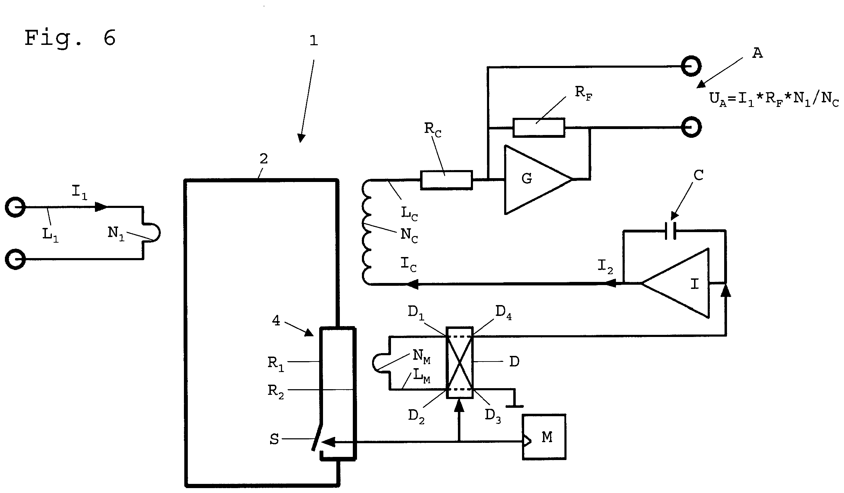

Der in Fig. 6 dargestellte Schaltplan einer weiteren Ausführungsform eines Geräts 1 zur Messung von Strom unterscheidet sich gegenüber der durch Fig. 5 gezeigten Ausführungsform darin, dass kein zweiter Operationsverstärker K vorgesehen ist. Des Weiteren sind um die zwei Flusspfade R1a, R1b zwei einzelne Erregerwicklungen gewickelt (wie in Fig. 1 dargestellt) und mit der Modulator-Einheit verbunden. Die zwei Erregerwicklungen bilden zusammen einen magnetischen Schalter S, welcher die Flusspfade R₁ₐ, R_{1b} für magnetischen Fluss wie in der Ausführungsform gemäß Fig. 5 öffnen und schließen kann. Der Integrator I ist direkt mit der Kompensationswicklung L_{C} verbunden. Der funktionelle Unterschied des Geräts 1 besteht darin, dass in dem in Fig. 6 gezeigten Ausführungsbeispiel der Gleichstrom I₂, welcher das Ausgangssignal des Integrators I ist, direkt der Kompensationswicklung als Kompensationsstrom I_{C} zugeführt wird.

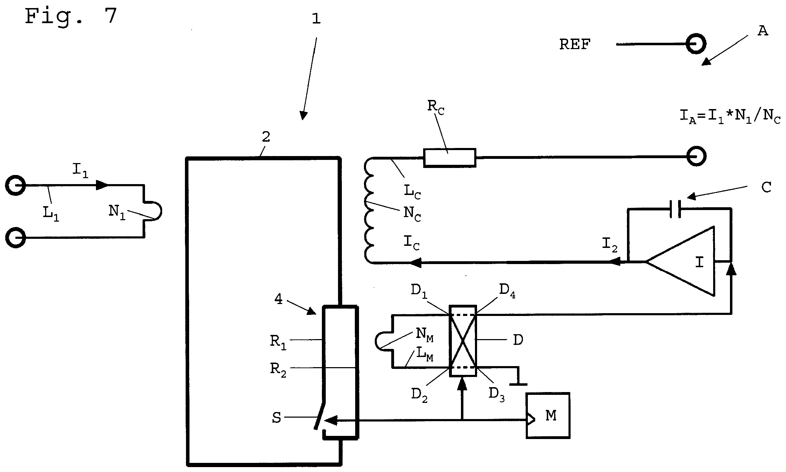

Der in Fig. 7 dargestellte Schaltplan einer weiteren Ausführungsform eines Geräts 1 zur Messung von Strom unterscheidet sich gegenüber der durch Fig. 6 gezeigten Ausführungsform darin, dass kein erster Operationsverstärker G vorgesehen ist, wodurch der Kompensationsstrom I_{C} = I₁ * N₁/N_{C} direkt am Ausgang A anliegt.

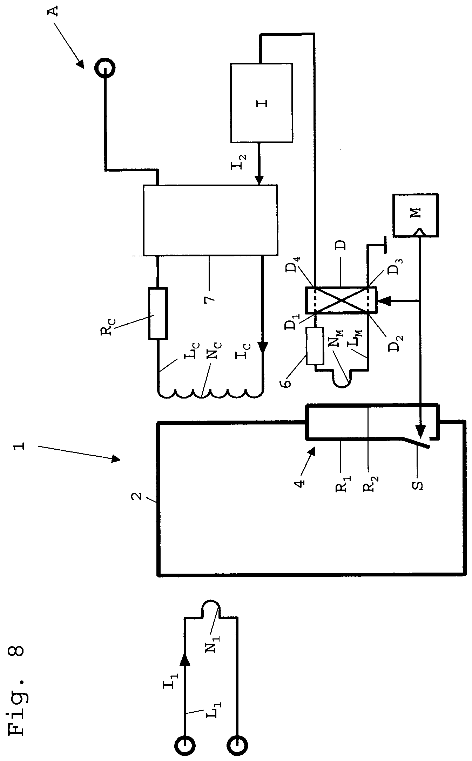

In Fig. 8 ist ein weiteres, den in Fig. 5 bis 7 dargestellten Ausführungsbeispielen ähnliches Ausführungsbeispiel des erfindungsgemäßen Geräts 1 zur Messung von Strom dargestellt. Die durch eine Messwicklung L_{M} erfasste Änderung des magnetischen Flusses in dem Messbereich 4 des magnetischen Kerns 2 wird einem an ein Ende der Messwicklung L_{M} angeschlossenen Analog/Digital-Wandler 6 zugeführt. Der Spannungsanteil der Änderung des magnetischen Flusses wird durch den Analog/Digital-Wandler 6 in ein digitales Signal gewandelt. Der Analog/digital Wandler 6 kann beispielsweise durch einen nicht dargestellten optionalen Buffer oder Verstärker an ein Ende der Messwicklung L_{M} angeschlossenen sein. Der Analog/Digital-Wandler 6 ist ausgangsseitig mit einem digitalen Demodulator D verbunden und stellt diesem die gewandelten digitalen Signale zur Verfügung.

Das digitale Ausgangssignal des digitalen Demodulators D wird einem Integrator I zur Verfügung gestellt, welcher durch einen I-, PI-, PID-Regler oder einen anderen geeigneten Regler gebildet werden kann. Das Ausgangssignal des Integrators I ist ein den Gleichstrom I₂ repräsentierendes digitales Signal, welches der Funktionseinheit 7 zugeführt wird. Die Funktionseinheit 7 ist in dem dargestellten Ausführungsbeispiel in Bezug auf ihre Signale gemischt digital analog implementiert. Die Funktionseinheit 7 umfasst die in Fig. 5 dargestellten Operationsverstärker G und K und einen nicht dargestellten Digital/Analog-Wandler, welcher das Ausgangssignal des Integrators I in einen analogen Wert wandeln und das gewandelte Signal dem ersten Operationsverstärkern G oder dem zweiten Operationsverstärker K zuführen kann. Die Operationsverstärker liefern, wie in Fig. 5 dargestellt, den Kompensationsstrom I_{C} für die Kompensationswicklung L_{C}. Der Kompensationsstrom L_{C} wird durch geeignete Mittel in der Funktionseinheit 7 in ein digitales Signal umgesetzt, welches als Ausgangssignal am Ausgang A zur Verfügung steht. Alternativ kann auch vorgesehen sein, dass alle Bauteile nach dem Analog/Digital-Wandler 6, das heißt der Demodulator D, der Integrator I und die Operationsverstärker G und K in der Funktionseinheit 7 vollständig digital implementiert sind.

## Patentansprüche

1. Gerät (1) zur Messung von Strom umfassend einen magnetischen Kern (2) mit einem ersten Durchbruch (3), durch welchen ein Primärleiter (L₁) verläuft, wobei der magnetische Kern (2) wenigstens einen Messbereich (4) mit wenigstens zwei zweiten Durchbrüchen (5) aufweist, welche den Messbereich (4) in wenigstens drei benachbarte Flusspfade (R₁ₐ, R_{1b}, R₂, R₂ₐ, R_{2b}) teilen,
wobei
- wenigstens eine Messwicklung (L_{M}) ist um Teile des Messbereichs (4) gewickelt;
das Gerät ist **dadurch gekennzeichnet, dass**
- um Teile des Kerns (2) außerhalb des Messbereichs (4) ist eine Kompensationswicklung (L_{C}) gewickelt;
- wenigstens zwei Flusspfade (R₁ₐ, R_{1b}, R₂ₐ, R_{2b}) des Messbereichs (4) sind von wenigstens einer Erregerwicklung (L_{S}) umwickelt.

2. Gerät (1) nach Anspruch 1,
**dadurch gekennzeichnet,**
**dass** das Gerät (1)
- einen Messbereich (4) mit zwei den Messbereich (4) in drei benachbarte Flusspfade (R₁ₐ, R_{1b}, R₂) teilenden Durchbrüchen (5),
- eine mit unterschiedlicher Orientierung um zwei Flusspfade (R₁ₐ, R_{1b}) gewickelte Erregerwicklung (L_{S}) und
- eine um den übrigen Flusspfad (R₂) gewickelte Messwicklung (L_{M}) aufweist.

3. Gerät (1) nach Anspruch 1,
**dadurch gekennzeichnet,**
**dass** das Gerät (1)
- zwei Messbereiche (4) mit jeweils zwei die Messbereiche (4) in drei benachbarte Flusspfade (R₁ₐ, R_{1b}, R₂) teilenden Durchbrüchen (5),
- zwei mit unterschiedlicher Orientierung um jeweils zwei Flusspfade (R₁ₐ, R_{1b}) der Messbereiche (4) gewickelten Erregerwicklungen (L_{S}),
- eine um den übrigen Flusspfad (R₂) eines der Messbereiche (4) gewickelte Messwicklung (L_{M}) und/oder
- eine um den übrigen Flusspfad (R₂) des anderen Messbereichs (4) gewickelte Messwicklung (L_{M})
aufweist.

4. Gerät (1) nach Anspruch 1,
**dadurch gekennzeichnet,**
**dass** das Gerät (1)
- einen Messbereich (4) mit drei den Messbereich (4) in ein erstes Paar benachbarter Flusspfade (R₁ₐ, R_{1b}) und ein zweites Paar benachbarter Flusspfade (R₂ₐ, R_{2b}) teilenden Durchbrüchen (5) und
- zwei mit unterschiedlicher Orientierung um jeweils ein Paar benachbarter Flusspfade (R₁ₐ, R_{1b}, R₂ₐ, R_{2b}) gewickelte Erregerwicklungen (L_{S})
aufweist.

5. Gerät (1) nach Anspruch 4,
**dadurch gekennzeichnet,**
**dass**
- eine Messwicklung (L_{M}) um das erste Paar benachbarter Flusspfade (R₁ₐ, R_{1b}) gewickelt ist und/oder
- eine Messwicklung (L_{M}) um das zweite Paar benachbarter Flusspfade (R₂ₐ, R_{2b}) gewickelt ist.

6. Gerät (1) nach Anspruch 4
**dadurch gekennzeichnet,**
**dass**
- der mittlere der Durchbrüche (5) eine größere Ausdehnung hat als die Flusspfade (R₁ₐ, R_{1b}, R₂ₐ, R_{2b}) und dadurch
- eine erste gemeinsame Verlängerung (R₁) des ersten Paars benachbarter Flusspfade (R₁ₐ, R_{1b}) und
- eine zweite gemeinsame Verlängerung (R₄) des zweiten Paars benachbarter Flusspfade (R₂ₐ, R_{2b}) definiert,
- eine Messwicklung (L_{M}) um die erste gemeinsame Verlängerung (R₁) gewickelt ist und/oder
- eine Messwicklung (L_{M}) um die zweite gemeinsame Verlängerung (R₄) gewickelt ist.

7. Gerät (1) nach einem der Ansprüche 1 bis 6,
**dadurch gekennzeichnet,**
**dass** die wenigstens eine Erregerwicklung (L_{S}) mit einer Modulator-Einheit (M) verbunden ist.

8. Gerät (1) nach Anspruch 7,
**dadurch gekennzeichnet,**
**dass** ein Demodulator (D) mit der wenigstens einen Messwicklung (L_{M}) verbunden ist und mit der Modulator-Einheit (M) synchronisierbar ist.

9. Gerät (1) nach Anspruch 8,
**dadurch gekennzeichnet,**
**dass** ein Integrator (I) mit dem Demodulator (D) verbunden ist.

10. Gerät (1) nach einem der Ansprüche 1 bis 9,
**dadurch gekennzeichnet,**
**dass** ein Ausgang (A) direkt oder indirekt über einen ersten Operationsverstärker (G) mit der Kompensationswicklung (L_{C}) verbunden ist.

11. Gerät (1) nach einem der Ansprüche 9 oder 10,
**dadurch gekennzeichnet,**
**dass** der Integrator (I) mit der Kompensationswicklung (L_{C}) verbunden ist.

12. Gerät (1) nach Anspruch 10,
**dadurch gekennzeichnet,**
**dass** der Integrator (I) mit einem zweiten Operationsverstärker (K) verbunden ist, welcher mit der Kompensationswicklung (L_{C}) und dem ersten Operationsverstärker (G) verbunden ist.

13. Gerät (1) nach einem der vorhergehenden Ansprüche, **dadurch gekennzeichnet, dass** die Messwicklung (L_{M}) einen Analog/Digital-Wandler (6) umfasst.

14. Gerät (1) nach einem der Ansprüche 10 bis 13, **dadurch gekennzeichnet, dass** der erste Operationsverstärker (G) und der zweite Operationsverstärker (K) zusammen digital und analog implementiert werden.

15. Verfahren zur Ermittlung von Strom unter Verwendung eines Geräts (1) nach einem der vorhergehenden Ansprüche mit den folgenden Verfahrensschritten:
- Leiten eines Primärstromes (I₁) durch den Primärleiter (L₁) und dadurch Hervorrufen eines magnetischen Flusses in dem Kern (2);
- Leiten eines Kompensationsstromes (I_{C}) durch die Kompensationswicklung (L_{C}) und dadurch Hervorrufen eines magnetischen Flusses in dem Kern, um dem durch den Primärleiter (L₁) hervorgerufenen magnetischen Fluss entgegenzuwirken;
- Periodisches Erregen der wenigstens einen Erregerwicklung (L_{S}) und dadurch, sofern erregt, Hervorrufen eines magnetischen Flusses in wenigstens zwei von der wenigstens einen Erregerwicklung (L_{S}) umwickelten Flusspfaden (R₁ₐ, R_{1b}, R₂ₐ, R_{2b}) und dadurch magnetisches Modulieren genannter Flusspfade (R₁ₐ, R_{1b}, R₂ₐ, R_{2b});
- Erfassen der Änderung des magnetischen Flusses mittels der wenigstens einen Messwicklung (L_{M}) zwischen verschiedenen Erregungszuständen der Erregerwicklung (L_{S}) zur Ableitung eines Demodulations-Signals zur Regelung des durch die Kompensationswicklung (L_{C}) hervorgerufenen magnetischen Flusses;
- Einstellen des Kompensationsstromes (I_{C}) auf einen Wert, so dass die durch die Messwicklung (L_{M}) erfasste Änderung des magnetischen Flusses minimiert ist;
- Messen des Kompensationsstromes (I_{C});
- Berechnen des Primärstromes (I₁) aus dem Kompensationsstrom (I_{C}).

16. Verfahren nach Anspruch 15,
**dadurch gekennzeichnet,**
**dass** zwei Erregerwicklungen (L_{S}) entgegengesetzt betrieben werden.

17. Verfahren nach Anspruch 15 oder 16,
**dadurch gekennzeichnet,**
**dass** die Enden der Messwicklung (L_{M}) mittels des Demodulators (D) abwechselnd mit dem Eingang des Integrators (I) verbunden werden.

18. Verfahren nach Anspruch 17,
**dadurch gekennzeichnet,**
**dass** der Demodulator (D) mit der Modulator-Einheit (M) synchronisiert ist.

19. Verfahren nach Anspruch 17 oder 18,
**dadurch gekennzeichnet,**
**dass** das Ausgangssignal des Demodulators (D) mittels des Integrators (I) in den Kompensationsstrom (I_{C}) umgewandelt wird.

20. Verfahren nach Anspruch 17 oder 18,
**dadurch gekennzeichnet,**
**dass** das Ausgangssignal des Demodulators mittels des Integrators (I) und des zweiten Operationsverstärkers (K), welcher ein Rückkopplungssignal von dem ersten Operationsverstärker (G) empfängt, in den Kompensationsstrom (I_{C}) umgewandelt wird.

21. Verfahren nach einem der Ansprüche 15 bis 20, **gekennzeichnet durch** Messen der Induktivität der wenigstens einen Erregerwicklung (L_{S}) und Erzeugen eines Signals, welches anzeigt, ob die jeweils gemessene Induktivität in einem bestimmten Bereich liegt oder nicht.

22. Gerät (1) nach Anspruch 1 mit einer Modulator-Einheit (M) mit den folgenden Merkmalen:
- die wenigstens eine Erregerwicklung (L_{S}) ist mit der Modulator-Einheit (M) verbunden,
- entweder eine Erregerwicklung (L_{S}) ist um zwei Flusspfade (R₁ₐ, R_{1b}, R₂ₐ, R_{2b}) des Messbereichs (4) gewickelt, oder zwei Erregerwicklungen (L_{S}) sind um jeweils einen der Flusspfade (R₁ₐ, R_{1b}, R₂ₐ, R_{2b}) des Messbereichs (4) gewickelt und
- die wenigstens eine als magnetischer Schalter wirkende Erregerwicklung (L_{S}) ist mittels der Modulator-Einheit (M) periodisch erregbar, um, sofern erregt, einen magnetischen Fluss in den zwei von der wenigstens einen Erregerwicklung (L_{S}) umwickelten Flusspfaden (R₁ₐ, R_{1b}, R₂ₐ, R_{2b}) hervorzurufen.

23. Gerät (1) nach Anspruch 22,
**dadurch gekennzeichnet,**
**dass** eine Erregerwicklung (L_{S}) mit unterschiedlicher Orientierung um zwei Flusspfade (R₁ₐ, R_{1b}, R₂ₐ, R_{2b}) gewickelt ist.

## Claims

1. A device (1) for measuring current, comprising a magnetic core (2) with a first opening (3) through which a primary conductor (L₁) is routed,
wherein the magnetic core (2) has at least one measuring region (4) with at least two second openings (5), which subdivide the measuring region (4) into at least three adjacent flux paths (R₁ₐ, R_{1b}, R₂, R₂ₐ, R_{2b}),
wherein
- at least one measuring winding (L_{M}) is wound around parts of the measuring region (4);
the device **characterized in that**
- a compensating winding (L_{C}) is wound around parts of the core (2) outside the measuring region (4);
- at least two flux paths (R₁ₐ, R_{1b}, R₂ₐ, R_{2b}) of the measuring region (4) are wound by at least one exciter winding (L_{S}).

2. The device (1) according to claim 1,
**characterized in that**
the device (1) comprises
- a measuring region (4) with two openings (5) subdividing the measuring region (4) into three adjacent flux paths (R₁ₐ, R_{1b}, R₂),
- one exciter winding (L_{S}) wound with different orientation around two flux paths (R₁ₐ, R_{1b}) and
- one measuring winding (L_{M}) wound around the other flux path (R₂) .

3. The device (1) according to claim 1,
**characterized in that**
the device (1) comprises
- two measuring regions (4) with respectively two openings (5) subdividing the measuring regions (4) into three adjacent flux paths (R₁ₐ, R_{1b}, R₂),
- two exciter windings (L_{S}) wound with different orientation around respectively two flux paths (R₁ₐ, R_{1b}) of the measuring regions (4),
- one measuring winding (L_{M}) wound around the other flux path (R₂) of one of the measuring regions (4) and/or
- one measuring winding (L_{M}) wound around the other flux path (R₂) of the other measuring region (4).

4. The device (1) according to claim 1,
**characterized in that**
the device (1) comprises
- a measuring region (4) with three openings (5) subdividing the measuring region (4) into a first pair of adjacent flux paths (R₁ₐ, R_{1b}) and a second pair of adjacent flux paths (R₂ₐ, R_{2b}) and
- two exciter windings (L_{S}) wound with different orientation around respectively one pair of adjacent flux paths (R₁ₐ, R_{1b}, R₂ₐ, R_{2b}).

5. The device (1) according to claim 4,
**characterized in that**
- one measuring winding (L_{M}) is wound around the first pair of adjacent flux paths (R₁ₐ, R_{1b}) and/or
- one measuring winding (L_{M}) is wound around the second pair of adjacent flux paths (R₂ₐ, R_{2b}) .

6. The device (1) according to claim 4,
**characterized in that**
- the middle of the openings (5) has a larger extent that the flux paths (R₁ₐ, R_{1b}, R₂ₐ, R_{2b}) and thereby
- defines a first common extension (R₁) of the first pair of adjacent flux paths (R₁ₐ, R_{1b}) and
- a second common extension (R₄) of the second pair of adjacent flux paths (R₂ₐ, R_{2b}),
- one measuring winding (L_{M}) is wound around the first common extension (R₁) and/or
- one measuring winding (L_{M}) is wound around the second common extension (R₄).

7. The device (1) according to one of claims 1 to 6,
**characterized in that**
the at least one exciter winding (L_{S}) is connected to a modulator unit (M).

8. The device (1) according to claim 7,
**characterized in that**
a demodulator (D) is connected to the at least one measuring winding (L_{M}) and can be synchronized with the modulator unit (M).

9. The device (1) according to claim 8,
**characterized in that**
an integrator (I) is connected to the demodulator (D).

10. The device (1) according to one of claims 1 to 9,
**characterized in that**
an output (A) is connected directly or indirectly via a first operational amplifier (G) to the compensating winding (L_{C}).

11. The device (1) according to one of claims 9 or 10,
**characterized in that**
the integrator (I) is connected to the compensating winding (L_{C}).

12. The device (1) according to claim 10,
**characterized in that**
the integrator (I) is connected to a second operational amplifier (K), which is connected to the compensating winding (L_{C}) and the first operational amplifier (G).

13. The device (1) according to one of the preceding claims,
**characterized in that** the measuring winding (L_{M}) comprises an analog-to-digital converter (6).

14. The device (1) according to one of claims 10 to 13,
**characterized in that** the first operational amplifier (G) and the second operational amplifier (K) are implemented together as digital and analog components.

15. A method for determining current using a device (1) according to one of the preceding claims, with the following process steps:
- Passing a primary current (Ii) through the primary conductor (L₁) and thereby inducing a magnetic flux in the core (2);
- Passing a compensating current (I_{C}) through the compensating winding (L_{C}) and thereby inducing a magnetic flux in the core, in order to counteract the magnetic flux induced by the primary conductor (L₁);
- Periodically energizing the at least one exciter winding (L_{S}) and thereby, to the extent energized, inducing a magnetic flux in at least two flux paths (R₁ₐ, R_{1b}, R₂ₐ, R_{2b}) wound by the at least one exciter winding (L_{S}) and thereby modulating the said flux paths (R₁ₐ, R_{1b}, R₂ₐ, R_{2b}) magnetically;
- Sensing, by means of the at least one measuring winding (L_{M}), the change of the magnetic flux between various energization conditions of the exciter winding (L_{S}), in order to derive a demodulation signal for regulation of the magnetic flux induced by the compensating winding (L_{C});
- Setting the compensating current (I_{C}) to a value such that the change of magnetic flux sensed by the measuring winding (L_{M}) is minimized;
- Measuring the compensating current (I_{C});
- Calculating the primary current (I₁) from the compensating current (I_{C}).

16. The method according to claim 15,
**characterized in that**
two exciter windings (L_{S}) are operated in opposition.

17. The method according to claim 15 or 16,
**characterized in that**,
by means of the demodulator (D), the ends of the measuring winding (L_{M}) are connected alternately to the input of the integrator (I).

18. The method according to claim 17,
**characterized in that**
the demodulator (D) is synchronized with the modulator unit (M) .

19. The method according to claim 17 or 18,
**characterized in that**
the output signal of the demodulator (D) is converted by means of the integrator (I) into the compensating current (I_{C}) .

20. The method according to claim 17 or 18,
**characterized in that**
the output signal of the demodulator is converted into the compensating current (I_{C}) by means of the integrator (I) and the second operational amplifier (K), which receives a feedback signal from the first operational amplifier (G).

21. The method according to one of claims 15 to 20,
**characterized by** measuring the inductance of the at least one exciter winding (L_{S}) and generating a signal that indicates whether or not the respective measured inductance lies within a specified range.

22. The device (1) according to claim 1 with a modulator unit (M) with the following features:
- the at least one exciter winding (L_{S}) is connected to the modulator unit (M),
- either one exciter winding (L_{S}) is wound around two flux paths (R₁ₐ, R_{1b}, R₂ₐ, R_{2b}) of the measuring region (4), or two exciter windings (Ls) are wound around respectively one of the flux paths (R₁ₐ, R_{1b}, R₂ₐ, R_{2b}) of the measuring region (4) and
- the at least one exciter winding (L_{S}), which acts as a magnetic switch, can be energized periodically by means of the modulator unit (M) in order, to the extent that it is energized, to induce a magnetic flux in the two flux paths (R₁ₐ, R_{1b}, R₂ₐ, R_{2b}) wound by the at least one exciter winding (L_{S}).

23. The device (1) according to claim 22,
**characterized in that**
one exciter winding (L_{S}) is wound with different orientation around two flux paths (R₁ₐ, R_{1b}, R₂ₐ, R_{2b}).

## Revendications

1. Appareil (1) destiné à la mesure de courant comprenant un noyau magnétique (2) avec un premier passage (3) à travers lequel passe un conducteur primaire (L₁), sachant que
le noyau magnétique (2) comporte au moins une zone de mesure (4) avec au moins deux deuxièmes passages (5), lesquels divisent la zone de mesure (4) en au moins trois voies de flux voisins (R₁ₐ, R_{1b}, R₂, R₂ₐ, R_{2b}),
sachant qu'
- au moins un bobinage de mesure (L_{M}) est enroulé autour des parties de la zone de mesure (4),
l'appareil est de ce fait **caractérisé en ce qu'**
- un bobinage de compensation (L_{C}) est enroulé autour des parties du noyau (2) en dehors des zones de mesure (4),
- au moins deux chemins de flux (R₁ₐ, R_{1b}, R₂ₐ, R_{2b}) de la zone de mesure (4) sont entourés d'au moins un bobinage d'excitation (L_{S}).

2. Appareil (1) selon la revendication 1,
**caractérisé en ce**
**que** l'appareil (1) comporte
- une zone de mesure (4) deux passages (5) divisant la zone de mesure (4) en trois voies de flux voisins (R₁ₐ, R_{1b}, R₂),
- un bobinage d'excitation (L_{S}) enroulé avec une orientation différente autour de deux chemins de flux (R₁ₐ, R_{1b}) et
- un bobinage de mesure (L_{M}) enroulé autour du chemin de flux (R₂) restant.

3. Appareil (1) selon la revendication 1,
**caractérisé en ce**
**que** l'appareil (1) comporte
- deux zones de mesure (4) avec respectivement deux passages (5) divisant les zones de mesure (4) en trois chemins de flux voisins (R₁ₐ, R_{1b}, R₂),
- deux bobinages d'excitation (L_{S}) avec une orientation différente enroulés respectivement autour de deux chemins de flux (R₁ₐ, R_{1b}) des zones de mesure (4),
- un bobinage de mesure (L_{M}) enroulé autour de la chemin de flux (R₂) restante d'une des zones de mesure (4) et/ou
- un bobinage de mesure (L_{M}) enroulé autour du chemin de flux (R₂) restant de l'autre zone de mesure (4).

4. Appareil selon la revendication 1,
**caractérisé en ce**
**que** l'appareil comporte
- une zone de mesure (4) avec trois passages (5) divisant la zone de mesure (4) en une première paire de chemins de flux (R₁ₐ, R_{1b}) voisins et une deuxième paire de chemins de flux (R₂ₐ, R_{2b}) des zones de mesure (4) et
- deux bobinages d'excitation (L_{S}) enroulés avec une orientation différente respectivement autour d'une paire de chemins de flux (R₁ₐ, R_{1b}, R₂ₐ, R_{2b}).

5. Appareil (1) selon la revendication 4,
**caractérisé en ce**
**qu'**
- un bobinage de mesure (L_{M}) est enroulé autour de la première paire de chemins de flux (R₁ₐ, R_{1b}) voisins et/ou
- un bobinage de mesure (L_{M}) est enroulé autour de la deuxième paire de chemins de flux (R₂ₐ, R_{2b}).

6. Appareil (1) selon la revendication 4,
**caractérisé en ce**
**que**
- le passage central des passages (5) possède une extension plus grande que les chemins de flux (R₁ₐ, R_{1b}, R₂ₐ, R_{2b}) et
de ce fait
- définit un premier prolongement commun (R₁) de la première paire de chemins de flux (R₁ₐ, R_{1b}) et
- un deuxième prolongement commun (R₄) de la deuxième paire de chemins de flux (R₂ₐ, R_{2b}),
- un bobinage de mesure (L_{M}) est enroulé autour du premier prolongement commun (R₁) et/ou
- un bobinage de mesure (L_{M}) est enroulé autour du deuxième prolongement commun (R₄).

7. Appareil (1) selon l'une quelconque des revendications 1 à 6,
**caractérisé en ce**
**qu'**au moins un bobinage d'excitation (L_{S}) est relié à une unité de modulateur (M).

8. Appareil (1) selon la revendication 7,
**caractérisé en ce**
**qu'**un démodulateur (D) est relié à au moins un bobinage de mesure (L_{M}) et peut être synchronisé avec l'unité de modulateur (M).

9. Appareil (1) selon la revendication 8,
**caractérisé en ce**
**qu'**un intégrateur (D) est relié au démodulateur (D).

10. Appareil (1) selon l'une quelconque des revendications 1 à 9,
**caractérisé en ce**
**qu'**une sortie (A) est directement ou indirectement reliée par un premier amplificateur opérationnel (G) au bobinage de compensation (L_{C}).

11. Appareil (1) selon la revendication 9 ou 10,
**caractérisé en ce**
**que** l'intégrateur (I) est relié au bobinage de compensation (L_{C}).

12. Appareil (1) selon la revendication 10,
**caractérisé en ce**
**que** l'intégrateur (I) est relié à un deuxième amplificateur opérationnel (K), lequel est relié au bobinage de compensation (L_{C}) et au premier amplificateur opérationnel (G).

13. Appareil (1) selon l'une quelconque des revendications précédentes, **caractérisé en ce que** le bobinage de mesure (L_{M}) comprend un convertisseur analogique/numérique (6) .

14. Appareil (1) selon l'une quelconque des revendications 10 à 13, **caractérisé en ce que** le premier amplificateur opérationnel (G) et le deuxième amplificateur opérationnel (K) sont mis en œuvre ensemble de façon numérique et analogique.

15. Procédé de détermination de courant utilisant un appareil (1) selon l'une quelconque des revendications précédentes avec les étapes de procédé suivantes :
- passage d'un courant primaire (I₁) à travers le conducteur primaire (L₁) et de ce fait provocation d'un flux magnétique dans le noyau (2),
- passage d'un courant de compensation (I_{C}) à travers le bobinage de compensation (L_{C}) et de ce fait, provocation d'un flux magnétique dans le noyau pour s'opposer au flux magnétique causé par le conducteur primaire (L₁),
- excitation périodique d'au moins un bobinage d'excitation (L_{S}) et de ce fait, en cas d'excitation, provocation d'un flux magnétique dans au moins deux chemins de flux (R₁ₐ, R_{1b}, R₂ₐ, R_{2b}) enroulés par au moins un bobinage d'excitation (L_{S}) et de ce fait modulation magnétique des chemins de flux cités (R₁ₐ, R_{1b}, R₂ₐ, R_{2b}),
- saisie de la variation du flux magnétique au moyen d'au moins un bobinage de mesure (L_{M}) entre différents états d'excitation du bobinage d'excitation (L_{S}) pour dériver un signal de démodulation destiné à la régulation du flux magnétique causé par le bobinage de compensation (L_{C}),
- réglage du courant de compensation (I_{C}) à une valeur de telle manière que la variation du flux magnétique saisie par le bobinage de mesure (L_{M}) est minimisée,
- mesure du courant de compensation (I_{C}),
- calcul du courant primaire (I₁) à partir du courant de compensation (I_{C}).

16. Procédé selon la revendication 15,
**caractérisé en ce**
**que** l'on fait fonctionner deux bobinages d'excitation (L_{S}) de façon opposée.

17. Procédé selon la revendication 15 ou 16,
**caractérisé en ce**
**que** les extrémités du bobinage de mesure (L_{M}) sont reliées au moyen du démodulateur (D) en alternance avec l'entrée de l'intégrateur (I).

18. Appareil selon la revendication 17,
**caractérisé en ce**
**que** le démodulateur (D) est synchronisé avec l'unité du modulateur (M).

19. Procédé selon la revendication 17 ou 18,
**caractérisé en ce**
**que** le signal de sortie du démodulateur (D) est converti au moyen de l'intégrateur (I) dans le courant de compensation (I_{C}).

20. Procédé selon la revendication 17 ou 18,
**caractérisé en ce**
**que** le signal de sortie du démodulateur est converti dans le courant de compensation (I_{C}) au moyen de l'intégrateur (I) et du deuxième amplificateur opérationnel (K), lequel reçoit un signal de réaction du premier amplificateur opérationnel (G).

21. Procédé selon l'une quelconque des revendications 15 à 20, **caractérisé par** la mesure de l'inductance d'au moins un bobinage d'excitation (L_{S}) et la production d'un signal, lequel indique si l'inductance respectivement mesurée se situe ou non dans une zone définie.

22. Appareil (1) selon la revendication 1 avec une unité de modulateur (M) avec les caractéristiques suivantes :
- au moins un bobinage d'excitation (L_{S}) est relié à l'unité de modulateur (M),
- soit un bobinage d'excitation (L_{S}) est enroulé autour de deux chemins de flux (R₁ₐ, R_{1b}, R₂ₐ, R_{2b}) de la zone de mesure (4), soit deux bobinages d'excitation (L_{S}) sont respectivement enroulés autour d'un des chemins de flux (R₁ₐ, R_{1b}, R₂ₐ, R_{2b}) de la zone de mesure (4) et
- au moins un bobinage d'excitation (L_{S}) agissant comme contacteur magnétique peut être périodiquement excité au moyen d'une unité de modulateur (M) pour, en cas d'excitation, provoquer un flux magnétique dans les deux chemins de flux (R₁ₐ, R_{1b}, R₂ₐ, R_{2b}) enroulés par au moins un bobinage d'excitation (L_{S}).

23. Appareil (1) selon la revendication 22,
**caractérisé en ce**
**qu'**un bobinage d'excitation (L_{S}) est enroulé avec une orientation différente autour de deux chemins de flux (R₁ₐ, R_{1b}, R₂ₐ, R_{2b}).
